# EUROPEAN PATENT SPECIFICATION

(11) **EP 4 174 941 B1**
(45) Date of publication and mention of the grant of the patent: **10.09.2025**
(21) Application number: 20941942.3
(22) Date of filing: 26.06.2020
(51) Int. Cl.: H10H 29/03, H10H 29/30, H01L 23/00

(54) **SUBSTRATE FOR MANUFACTURING DISPLAY APPARATUS AND METHOD FOR MANUFACTURING DISPLAY APPARATUS USING SAME**
SUBSTRAT ZUR HERSTELLUNG EINER ANZEIGEVORRICHTUNG UND VERFAHREN ZUR HERSTELLUNG EINER ANZEIGEVORRICHTUNG DAMIT
SUBSTRAT POUR LA FABRICATION D'APPAREIL D'AFFICHAGE ET PROCÉDÉ POUR LA FABRICATION D'APPAREIL D'AFFICHAGE L'UTILISANT

(43) Date of publication of application: 03.05.2023
(73) Proprietor: LG Electronics, Inc., Yeongdeungpo-gu Seoul 07336 (KR)
(72) Inventor: KIM, Kisu, Seoul 06772 (KR); LEE, Jinhyung, Seoul 06772 (KR); KIM, Gunho, Seoul 06772 (KR); KIM, Jungsub, Seoul 06772 (KR)
(74) Representative: Vossius & Partner Patentanwälte Rechtsanwälte mbB
(86) International application number: PCT/KR2020/008316
(87) International publication number: WO 2021/261627

(56) References cited:
- KR-A- 20180 020 239
- KR-A- 20190 092 330
- KR-A- 20200 003 942
- KR-A- 20200 021 966
- KR-A- 20200 026 683
- KR-A- 20200 026 768
- KR-A- 20200 026 768
- US-A1- 2013 214 302
- US-A1- 2020 203 321
- ANONYMOUS: "Dielectrophoresis - Wikipedia", 26 February 2020 (2020-02-26), pages 1 - 10, XP093129690, Retrieved from the Internet <URL:https://en.wikipedia.org/w/index.php?title=Dielectrophoresis&oldid=942848795> [retrieved on 20240209]

## Description

### Technical Field

The present disclosure relates to a substrate used for manufacturing a display apparatus using a semiconductor light-emitting device (hereinafter, micro-LED) having a size of several to tens of micrometers (µm), and a method for manufacturing a display apparatus using the same.

### Background Art

In recent years, in the field of display technology, displays using liquid crystal displays (LCDs), organic light-emitting diode displays (OLEDs), and micro-LEDs are competing against one another.

When a micro-LED is used as a pixel of a display apparatus, there is an advantage in that a polarizing plate or the like is not used, thereby providing high efficiency. However, since millions of devices are required to implement a large-area display, a high-level transfer technology is required.

Micro-LED transfer technologies currently being discussed include pick & place, laser lift-off (LLO), and self-assembly. Among them, self-assembly is a method in which semiconductor light-emitting devices find their own positions in a fluid, and is most advantageous for implementing a large-area display apparatus.

The semiconductor light-emitting devices may be directly transferred to a substrate (hereinafter, referred to as a final substrate) constituting the display apparatus through self-assembly, or may be primarily transferred to a donor substrate and then transferred back to the final substrate by a transfer stamp. The former is efficient in terms of process since the manufacturing time is shortened due to the transfer process performed only once, and the latter has an advantage capable of adding or changing a structure for performing self-assembly to the donor substrate without any limitation, and the two methods are selectively used.

KR 2020 0026768 A relates to a method of manufacturing a display device using a semiconductor light emitting device having a size of several to several tens of µm, and a self-assembly apparatus used therefor.

KR 2020 0026683 (A) relates to a method for manufacturing a display device using semiconductor light emitting diodes having a size of several µm to several tens of µm, and an assembly board for manufacture of the display device.

US 2020/203321 (A1) relates to a display device using a semiconductor light emitting device.

### Disclosure of Invention

### Technical Problem

An aspect of the present disclosure is to provide a substrate used for manufacturing a display apparatus using a micro-LED, and a method for manufacturing a display apparatus using the same.

In particular, an aspect of the present disclosure is to provide a method for simultaneously assembling RGB LEDs on a substrate for manufacturing a display apparatus, and a substrate used therefore, in order to manufacture a display apparatus composed of RGB LEDs.

### Solution to Problem

A substrate for manufacturing a display apparatus according to the present invention is disclosed as recited in claim 1.

According to the present disclosure, the pair electrodes may include first pair electrodes disposed at first intervals; second pair electrodes disposed at second intervals; and third pair electrodes disposed at third intervals.

According to the present disclosure, the cells may include first cells having a first shape to overlap the first pair electrodes; second cells having a second shape to overlap the second pair electrodes; and third cells having a third shape to overlap the third pair electrodes.

According to the present disclosure, the first pair electrodes, the second pair electrodes, and the third pair electrodes may be alternately disposed on the base portion.

According to the present invention, the substrate includes an electrode pad that applies a voltage to the pair electrodes, wherein the electrode pad includes a first electrode pad connected to either one electrode of the pair electrodes to apply a first signal thereto; and a second electrode pad connected to the other electrode of the pair electrodes to apply a second signal thereto.

According to the present disclosure, the first pair of electrodes, the second pair electrodes, and the third pair electrodes may be respectively connected to different first and second electrode pads.

A method for manufacturing a display apparatus according to the present invention is disclosed as recited in claim 6.

According to the present invention, alternating voltages having different frequencies are applied to the first pair electrodes, the second pair electrodes, and the third pair electrodes.

According to the present disclosure, the substrate may include first cells having a first shape to overlap the first pair electrodes, second cells having a second shape to overlap the second pair electrodes, and third cells having a third shape to overlap the third pair electrodes.

According to the present disclosure, the semiconductor light-emitting devices may include first semiconductor light-emitting devices having a first shape, second semiconductor light-emitting devices having a second shape, and third semiconductor light-emitting devices having a third shape, wherein the first semiconductor light-emitting device, the second semiconductor light-emitting device and the third semiconductor light-emitting device are semiconductor light-emitting devices emitting light of different colors.

According to the present disclosure, the semiconductor light-emitting devices may include semiconductor light-emitting devices having a higher electrical conductivity and a lower dielectric constant than the fluid, and semiconductor light-emitting devices having a lower electrical conductivity and a higher dielectric constant than the fluid.

According to the present disclosure, the semiconductor light-emitting devices may include a passivation layer disposed to cover surfaces of the semiconductor light-emitting devices, wherein the semiconductor light-emitting devices include semiconductor light-emitting devices in which at least one of a thickness and a material of the passivation layer is different.

### Advantageous Effects of Invention

According to the present disclosure, RGB LEDs may be simultaneously assembled on a substrate used for manufacturing a display apparatus, thereby reducing the number of transfers and shorting process time.

In addition, according to the present disclosure, a direction of dielectrophoretic force acting on RGB LEDs may be dichotomized to perform the assembly of RGB under exclusive conditions, thereby preventing color mixing due to simultaneous RGB assembly as well as improving assembly rate.

### Brief Description of Drawings

FIG. 1 is a conceptual view showing a display apparatus using a semiconductor light-emitting device according to an embodiment of the present disclosure.
FIG. 2 is a partially enlarged view showing a portion "A" of the display apparatus in FIG. 1.
FIG. 3 is an enlarged view showing a semiconductor light-emitting device in FIG. 2.
FIG. 4 is an enlarged view showing another embodiment of the semiconductor light-emitting device in FIG. 2.
FIGS. 5A to 5E are conceptual views for explaining a new process of manufacturing the foregoing semiconductor light-emitting device.
FIG. 6 is a conceptual view showing an example of a self-assembly device of semiconductor light-emitting devices according to the present disclosure.
FIG. 7 is a block diagram showing the self-assembly device in FIG. 6.
FIGS. 8A to 8E are conceptual views showing a process of self-assembling semiconductor light-emitting devices using the self-assembly device in FIG. 6.
FIG. 9 is a conceptual view for explaining the semiconductor light-emitting device used for the self-assembly process in FIGS. 8A to 8E.
FIGS. 10A to 10C are conceptual views showing a state in which semiconductor light-emitting devices are transferred subsequent to a self-assembly process according to the present disclosure.
FIGS. 11 to 13 are flowcharts showing a method of manufacturing a display apparatus including semiconductor light-emitting devices emitting red (R), green (G), and blue (B) light.
FIG. 14A is a view showing an embodiment of a substrate used for manufacturing a display apparatus in the related art, and FIG. 14B is a cross-sectional view taken along line A-A' of FIG. 14A.
FIG. 15 is a view showing an embodiment of a substrate used for manufacturing a display apparatus according to the present invention.
FIGS. 16A, 16B, and 17 are views showing other embodiments of a substrate used for manufacturing a display apparatus according to the present invention.
FIG. 18 is a view showing a structure in which an electrode pad is connected to the substrate according to FIG. 15.
FIG. 19 is a view showing a method of manufacturing a display apparatus according to the present invention.
FIGS. 20A to 20C are graphs showing assembly frequency characteristics of semiconductor light-emitting devices according to various embodiments of the present invention.

### Mode for the Invention

Hereinafter, the embodiments disclosed herein will be described in detail with reference to the accompanying drawings, and the same or similar elements are designated with the same numeral references regardless of the numerals in the drawings and their redundant description will be omitted. A suffix "module" and "unit" used for constituent elements disclosed in the following description is merely intended for easy description of the specification, and the suffix itself does not give any special meaning or function. In describing the embodiments disclosed herein, moreover, the detailed description will be omitted when specific description for publicly known technologies to which the invention pertains is judged to obscure the gist of the present disclosure. Also, it should be noted that the accompanying drawings are merely illustrated to easily explain the concept of the invention, and therefore, they should not be construed to limit the technological concept disclosed herein by the accompanying drawings. Furthermore, it will be understood that when an element such as a layer, region or substrate is referred to as being "on" another element, it can be directly on the other element or an intermediate element may also be interposed therebetween.

A display apparatus disclosed herein may include a mobile phone, a smart phone, a laptop computer, a digital broadcast terminal, a personal digital assistant (PDA), a portable multimedia player (PMP), a navigation, a slate PC, a tablet PC, an ultrabook, a digital TV, a desktop computer, and the like. However, even if a new product type to be developed later includes a display, a configuration according to an embodiment disclosed herein may be applicable thereto.

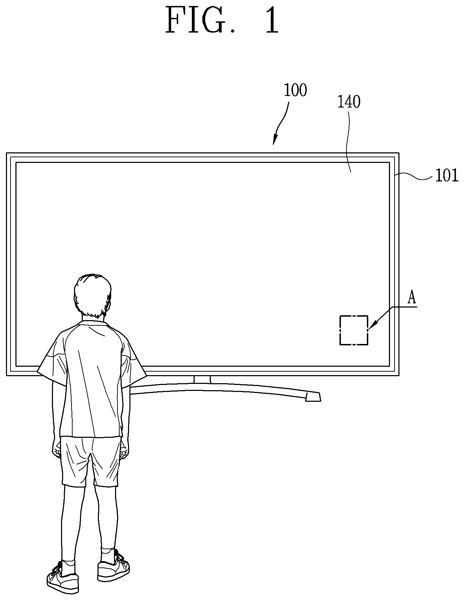

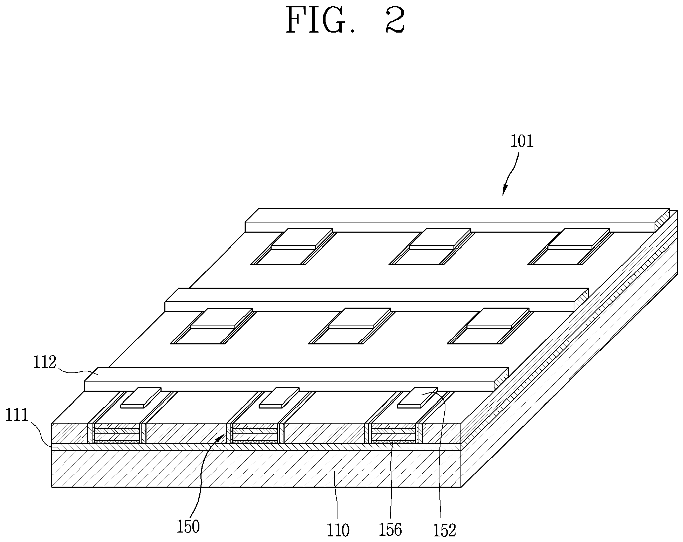

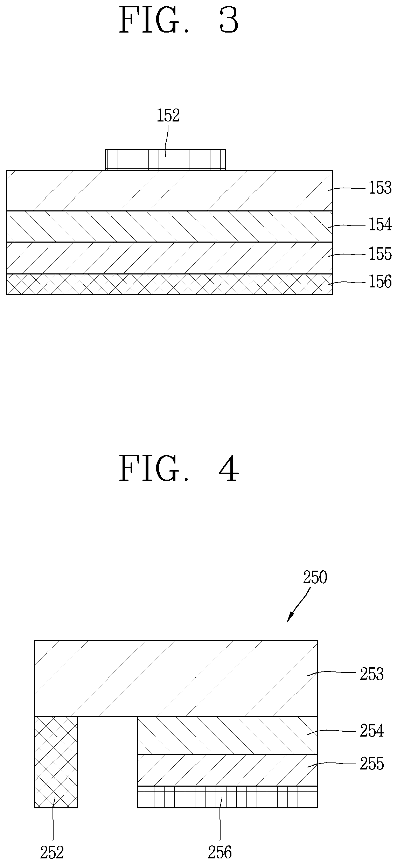

FIG. 1 is a conceptual view showing a display apparatus using a semiconductor light-emitting device according to an embodiment of the present disclosure, and FIG. 2 is a partially enlarged view showing a portion "A" of the display apparatus in FIG. 1, and FIG. 3 is an enlarged view showing a semiconductor light-emitting device in FIG. 2, and FIG. 4 is an enlarged view showing another embodiment of the semiconductor light-emitting device in FIG. 2.

According to the illustration, information processed in the controller of the display apparatus 100 may be displayed on a display module 140. A case 101 in the form of a closed loop surrounding an edge of the display module may define a bezel of the display apparatus.

The display module 140 may include a panel 141 on which an image is displayed, and the panel 141 may include micro-sized semiconductor light-emitting devices 150 and a wiring substrate 110 on which the semiconductor light-emitting devices 150 are mounted.

Wiring lines may be formed on the wiring substrate 110, and connected to an n-type electrode 152 and a p-type electrode 156 of the semiconductor light-emitting device 150. Through this, the semiconductor light-emitting device 150 may be provided on the wiring substrate 110 as a self-emitting individual pixel.

An image displayed on the panel 141 is visual information, and implemented by independently controlling the light emission of a sub-pixel arranged in a matrix form through the wiring lines.

According to the present disclosure, a micro light-emitting diode (LED) is illustrated as one type of the semiconductor light-emitting device 150 that converts current into light. The micro-LED may be a light-emitting diode formed with a small size of 100 microns or less. The semiconductor light-emitting device 150 may be provided in blue, red, and green light emitting regions, respectively, to implement a sub-pixel by a combination of the light-emitting regions. In other words, the sub-pixel denotes a minimum unit for implementing a single color, and at least three micro-LEDs may be provided in the sub-pixel.

More specifically, referring to FIG. 3, the semiconductor light-emitting device 150 may be a vertical structure.

For example, the semiconductor light-emitting devices 150 may be implemented with a high-power light-emitting device that emits various lights including blue in which gallium nitride (GaN) is mostly used, and indium (In) and or aluminum (Al) are added thereto.

The vertical semiconductor light-emitting device may include a p-type electrode 156, a p-type semiconductor layer 155 formed with the p-type electrode 156, an active layer 154 formed on the p-type semiconductor layer 155, an n-type semiconductor layer 153 formed on the active layer 154, and an n-type electrode 152 formed on the n-type semiconductor layer 153. In this case, the p-type electrode 156 located at the bottom may be electrically connected to a p-electrode of the wiring substrate, and the n-type electrode 152 located at the top may be electrically connected to an n-electrode at an upper side of the semiconductor light-emitting device. The electrodes may be disposed in a top-down direction in the vertical semiconductor light-emitting device 150, thereby providing a great advantage capable of reducing a chip size.

For another example, referring to FIG. 4, the semiconductor light-emitting device may be a flip chip type semiconductor light-emitting device.

For such an example, the semiconductor light-emitting device 250 may include a p-type electrode 256, a p-type semiconductor layer 255 formed with the p-type electrode 256, an active layer 254 formed on the p-type semiconductor layer 255, an n-type semiconductor layer 253 formed on the active layer 254, and an n-type electrode 252 disposed to be separated from the p-type electrode 256 in the horizontal direction on the n-type semiconductor layer 253. In this case, both the p-type electrode 256 and the n-type electrode 252 may be electrically connected to the p-electrode and the n-electrode of the wiring substrate at the bottom of the semiconductor light-emitting device.

The vertical semiconductor light-emitting device and the horizontal semiconductor light-emitting device may be a green semiconductor light-emitting device, a blue semiconductor light-emitting device, or a red semiconductor light-emitting device, respectively. The green semiconductor light-emitting device and the blue semiconductor light-emitting device may be mostly formed of gallium nitride (GaN), and indium (In) and/or aluminum (Al) may be added thereto to implement a high-power light-emitting device that emits green or blue light. For such an example, the semiconductor light-emitting device may be a gallium nitride thin-film formed in various layers such as n-Gan, p-Gan, AlGaN, and InGa, and specifically, the p-type semiconductor layer may be p-type GaN, and the n-type semiconductor layer may be N-type GaN. However, in case of the red semiconductor light-emitting device, the p-type semiconductor layer may be p-type GaAs and the n-type semiconductor layer may be n-type GaAs.

In addition, a p-electrode side in the p-type semiconductor layer may be p-type GaN doped with Mg, and an n-electrode side in the n-type semiconductor layer may be n-type GaN doped with Si. In this case, the above-described semiconductor light-emitting devices may be semiconductor light-emitting devices without an active layer.

On the other hand, referring to FIGS. 1 to 4, since the light-emitting diode is very small, the display panel may be arranged with self-emitting sub-pixels arranged at fine pitches, thereby implementing a high-quality display apparatus.

In a display apparatus using the semiconductor light-emitting device of the present disclosure described above, a semiconductor light-emitting device grown on a wafer and formed through mesa and isolation is used as an individual pixel. In this case, the micro-sized semiconductor light-emitting device 150 must be transferred to a wafer at a predetermined position on the substrate of the display panel. Pick and place is used for the transfer technology, but the success rate is low and a lot of time is required. For another example, there is a technology of transferring a plurality of devices at one time using a stamp or a roll, but the yield is limited and not suitable for a large screen display. The present disclosure proposes a new fabrication method of a display apparatus capable of solving the foregoing problems and a fabrication apparatus using the same.

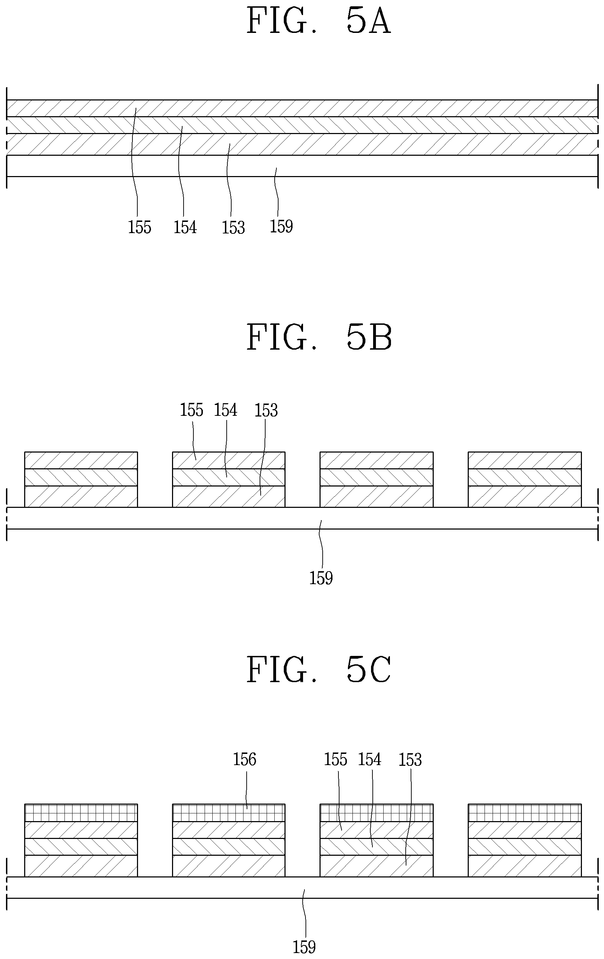

For this purpose, first, a new fabrication method of the display apparatus will be described. FIGS. 5A to 5E are conceptual views for explaining a new process of manufacturing the foregoing semiconductor light-emitting device.

In this specification, a display apparatus using a passive matrix (PM) semiconductor light-emitting device is illustrated. However, an example described below may also be applicable to an active-matrix (AM) type semiconductor light-emitting device. In addition, a method of self-assembling a horizontal semiconductor light-emitting device is illustrated, but it is also applicable to a method of self-assembling a vertical semiconductor light-emitting device.

First, according to a manufacturing method, a first conductive semiconductor layer 153, an active layer 154, and a second conductive semiconductor layer 155 are respectively grown on a growth substrate 159 (FIG. 5A).

When the first conductive semiconductor layer 153 is grown, next, the active layer 154 is grown on the first conductive semiconductor layer 153, and then the second conductive semiconductor layer 155 is grown on the active layer 154. As described above, when the first conductive semiconductor layer 153, the active layer 154 and the second conductive semiconductor layer 155 are sequentially grown, the first conductive semiconductor layer 153, the active layer 154, and the second conductive semiconductor layer 155 form a layer structure as illustrated in FIG. 5A.

In this case, the first conductive semiconductor layer 153 may be a p-type semiconductor layer, and the second conductive semiconductor layer 155 may be an n-type semiconductor layer. However, the present disclosure is not limited thereto, and the first conductive type may be n-type and the second conductive type may be p-type.

In addition, the present embodiment illustrates a case where the active layer is present, but it is also possible to adopt a structure in which the active layer is not present as described above. For such an example, the p-type semiconductor layer may be p-type GaN doped with Mg, and an n-electrode side in the n-type semiconductor layer may be n-type GaN doped with Si.

The growth substrate 159 (wafer) may be formed of any one of materials having light transmission properties, for example, sapphire (Al₂O₃), GaN, ZnO, and AlO, but is not limited thereto. Furthermore, the growth substrate 1059 may be formed of a carrier wafer, which is a material suitable for semiconductor material growth. The growth substrate (W) may be formed of a material having an excellent thermal conductivity, and for example, a SiC substrate having a higher thermal conductivity than a sapphire (Al₂O₃) substrate or a SiC substrate including at least one of Si, GaAs, GaP, InP and Ga2O3 may be used.

Next, at least part of the first conductive semiconductor layer 153, the active layer 154, and the second conductive semiconductor layer 155 is removed to form a plurality of semiconductor light-emitting devices (FIG. 5B).

More specifically, isolation is performed to allow a plurality of light-emitting devices to form a light-emitting device array. In other words, the first conductive semiconductor layer 153, the active layer 154, and the second conductive semiconductor layer 155 are etched in a vertical direction to form a plurality of semiconductor light-emitting devices.

If it is a case of forming the horizontal semiconductor light-emitting device, then the active layer 154 and the second conductive semiconductor layer 155 may be partially removed in a vertical direction to perform a mesa process in which the first conductive semiconductor layer 153 is exposed to the outside, and then isolation in which the first conductive semiconductor layer is etched to form a plurality of semiconductor light-emitting device arrays.

Next, a second conductive electrode 156 (or a p-type electrode) is respectively formed on one surface of the second conductive semiconductor layer 155 (FIG. 5C). The second conductive electrode 156 may be formed by a deposition process such as sputtering, but the present disclosure is not necessarily limited thereto. However, when the first conductive semiconductor layer and the second conductive semiconductor layer are an n-type semiconductor layer and a p-type semiconductor layer, respectively, the second conductive electrode 156 may also be an n-type electrode.

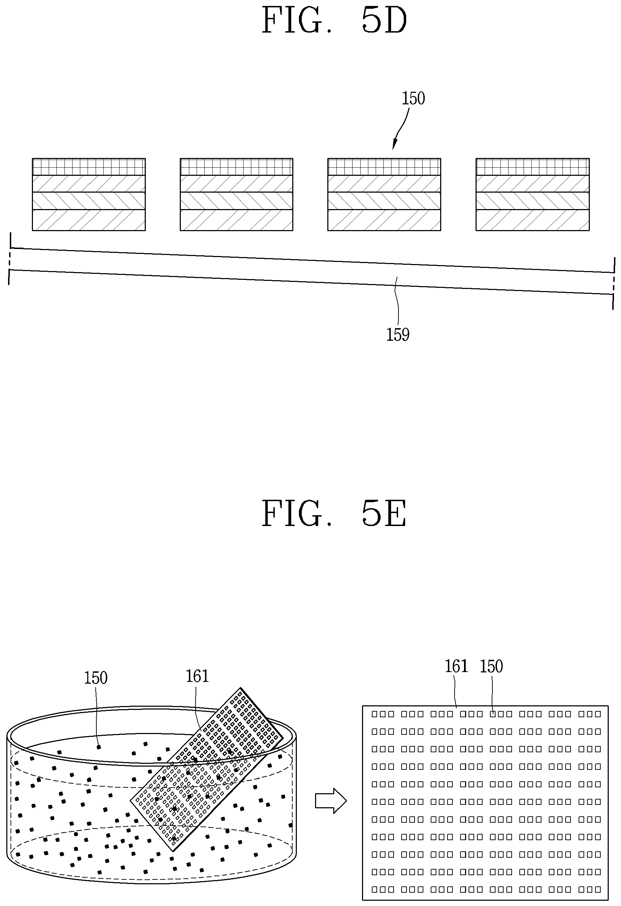

Then, the growth substrate 159 is removed to provide a plurality of semiconductor light-emitting devices. For example, the growth substrate 1059 may be removed using a laser lift-off (LLO) or chemical lift-off (CLO) method (FIG. 5D).

Then, the process of seating the semiconductor light-emitting devices 150 on the substrate in a chamber filled with a fluid is carried out (FIG. 5E).

For example, the semiconductor light-emitting devices 150 and the substrate are placed into a chamber filled with a fluid, and the semiconductor light-emitting devices are assembled to the substrate 1061 by themselves using flow, gravity, surface tension, or the like. In this case, the substrate may be an assembly substrate 161.

For another example, the wiring substrate may also be placed into the fluid chamber instead of the assembly substrate 161 such that the semiconductor light-emitting devices 150 are directly seated on the wiring substrate. In this case, the substrate can be a wiring substrate. However, for convenience of description, in the present disclosure, it is illustrated that the substrate is provided as an assembly substrate 161 and the semiconductor light-emitting devices 1050 are seated thereon.

Cells (not shown) into which the semiconductor light-emitting devices 150 are fitted may be provided on the assembly substrate 161 so that the semiconductor light-emitting devices 150 are easily seated on the assembly substrate 161. Specifically, cells on which the semiconductor light-emitting devices 150 are seated are formed on the assembly substrate 161 at positions where the semiconductor light-emitting devices 150 are aligned with the wiring electrodes. The semiconductor light-emitting devices 150 are assembled into the cells while moving in the fluid.

When the plurality of semiconductor light-emitting devices are arrayed on the assembly substrate 161, and then the semiconductor light-emitting devices on the assembly substrate 161 are transferred to the wiring substrate, it may enable large-area transfer. Therefore, the assembly substrate 161 may be referred to as a temporary substrate.

Meanwhile, the self-assembly method described above must increase transfer yield when applied to the fabrication of a large-screen display. The present disclosure proposes a method and apparatus for minimizing the influence of gravity or friction and preventing non-specific binding in order to increase the transfer yield.

In this case, in a display apparatus according to the present disclosure, a magnetic body is disposed on the semiconductor light-emitting device to move the semiconductor light-emitting device using a magnetic force, and seat the semiconductor light-emitting device at preset position using an electric field in the movement process. Hereinafter, such a transfer method and device will be described in more detail with reference to the accompanying drawings.

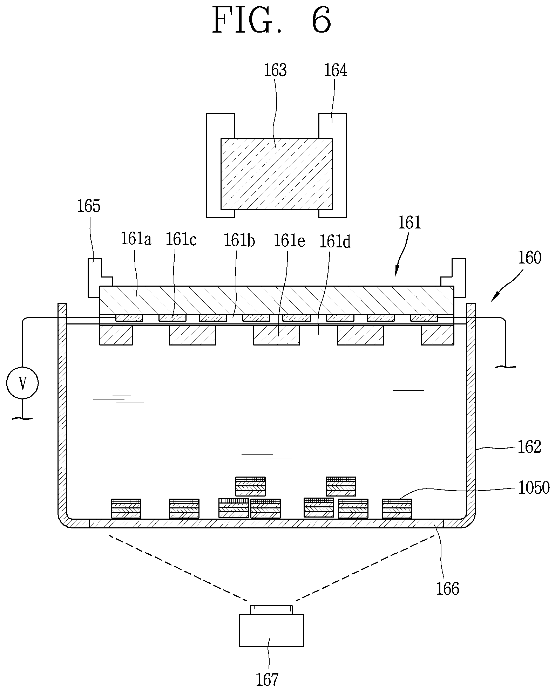

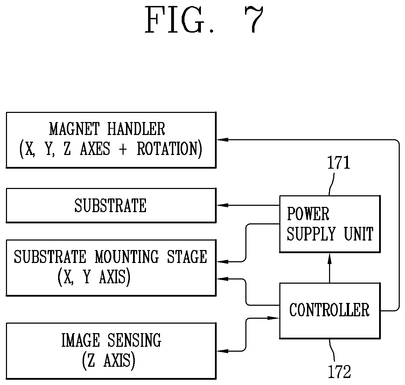

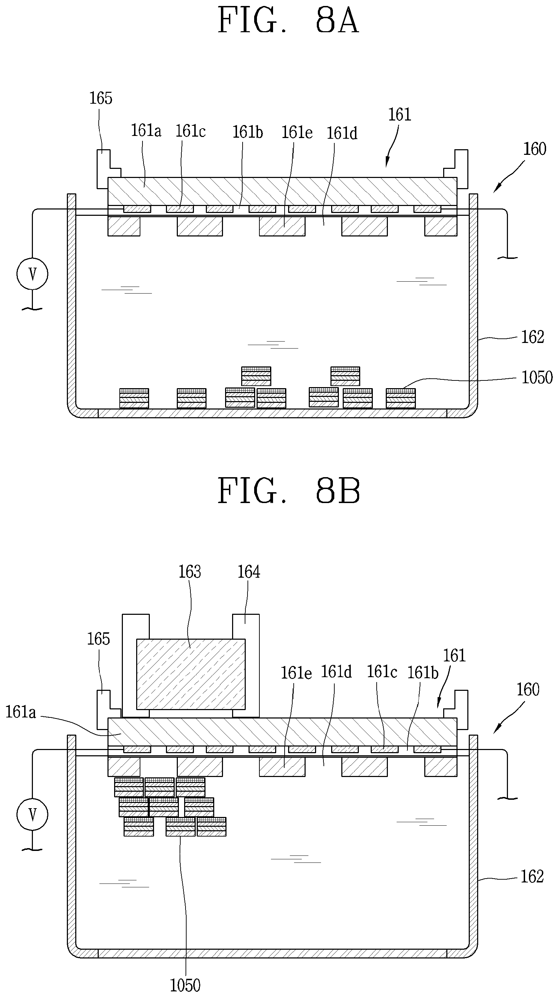

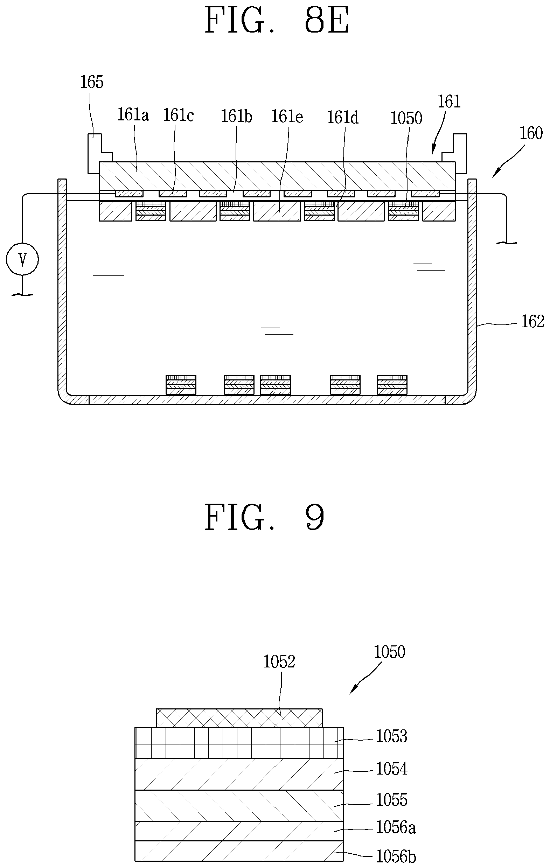

FIG. 6 is a conceptual view showing an example of a self-assembly device of semiconductor light-emitting devices according to the present disclosure, and FIG. 7 is a block diagram showing the self-assembly device in FIG. 6. FIGS. 8A to 8E are conceptual views showing a process of self-assembling semiconductor light-emitting devices using the self-assembly device in FIG. 6, and FIG. 9 is a conceptual view for explaining the semiconductor light-emitting device in FIGS. 8A to 8E.

According to the illustration of FIGS. 6 and 7, a self-assembly device 160 of the present disclosure may include a fluid chamber 162, a magnet 163, and a location controller 164.

The fluid chamber 162 has a space for accommodating a plurality of semiconductor light-emitting devices. The space may be filled with a fluid, and the fluid may include water or the like as an assembly solution. Accordingly, the fluid chamber 162 may be a water tank, and may be configured with an open type. However, the present disclosure is not limited thereto, and the fluid chamber 162 may be a closed type in which the space is formed with a closed space.

The substrate 161 may be disposed on the fluid chamber 162 such that an assembly surface on which the semiconductor light-emitting devices 150 are assembled faces downward. For example, the substrate 161 may be transferred to an assembly position by a transfer unit, and the transfer unit may include a stage 165 on which the substrate is mounted. The stage 165 is positioned by the controller, and the substrate 161 may be transferred to the assembly position through the stage 165.

At this time, the assembly surface of the substrate 161 faces the bottom of the fluid chamber 150 at the assembly position. According to the illustration, the assembly surface of the substrate 161 is disposed so as to be immersed in a fluid in the fluid chamber 162. Therefore, the semiconductor light-emitting devices 150 are moved to the assembly surface in the fluid.

The substrate 161, which is an assembly substrate on which an electric field can be formed, may include a base portion 161a, a dielectric layer 161b and a plurality of electrodes 161c.

The base portion 161a may be made of an insulating material, and the plurality of electrodes 161c may be a thin or a thick film bi-planar electrode patterned on one side of the base portion 161a. The electrode 161c may be formed of, for example, a stack of Ti/Cu/Ti, an Ag paste, ITO, and the like.

The dielectric layer 161b is made of an inorganic material such as SiO₂, SiNx, SiON, Al₂O₃, TiO₂, HfO₂, or the like. Alternatively, the dielectric layer 161b may be composed of a single layer or multiple layers as an organic insulator. A thickness of the dielectric layer 161b may be several tens of nanometers to several micrometers.

Furthermore, the substrate 161 according to the present disclosure includes a plurality of cells 161d partitioned by partition walls. The cells 161d may be sequentially arranged along one direction, and made of a polymer material. In addition, the partition wall 161e constituting the cells 161d is configured to be shared with neighboring cells 161d. The partition walls 161e are protruded from the base portion 161a, and the cells 161d may be sequentially arranged along the one direction by the partition walls 161e. More specifically, the cells 161d are sequentially arranged in row and column directions, and may have a matrix structure.

As shown in the drawing, an inside of the cells 161d has a groove for accommodating the semiconductor light-emitting device 150, and the groove may be a space defined by the partition walls 161e. The shape of the groove may be the same as or similar to that of the semiconductor light-emitting device. For example, when the semiconductor light-emitting device is in a rectangular shape, the groove may be a rectangular shape. In addition, although not shown, when the semiconductor light-emitting device is circular, the grooves formed in the cells may be formed in a circular shape. Moreover, each of the cells is configured to accommodate a single semiconductor light-emitting device. In other words, a single semiconductor light-emitting device is accommodated in a single cell.

Meanwhile, the plurality of electrodes 161c include a plurality of electrode lines disposed at the bottom of each of the cells 161d, and the plurality of electrode lines may be configured to extend to neighboring cells.

The plurality of electrodes 161c are disposed below the cells 161d and applied with different polarities to generate an electric field in the cells 161d. In order to form the electric field, the dielectric layer may form the bottom of the cells 161d while the dielectric layer covers the plurality of electrodes 161c. In such a structure, when different polarities are applied to a pair of electrodes 161c from a lower side of each cell 161d, an electric field may be formed, and the semiconductor light-emitting device may be inserted into the cells 161d by the electric field.

At the assembly position, the electrodes of the substrate 161 are electrically connected to the power supply unit 171. The power supply unit 171 applies power to the plurality of electrodes to generate the electric field.

According to the illustration, the self-assembly device may include a magnet 163 for applying a magnetic force to the semiconductor light-emitting devices. The magnet 163 is spaced apart from the fluid chamber 162 to apply a magnetic force to the semiconductor light-emitting devices 150. The magnet 163 may be disposed to face an opposite side of the assembly surface of the substrate 161, and the location of the magnet is controlled by the location controller 164 connected to the magnet 163.

The semiconductor light-emitting device 1050 may have a magnetic body so as to move in the fluid by the magnetic field of the magnet 163.

Referring to FIG. 9, the semiconductor light-emitting device of the display apparatus having a magnetic body may include a first conductive electrode 1052 and a second conductive electrode 1056, a first conductive semiconductor layer 1053 disposed with the first conductive electrode 1052, a second conductive semiconductor layer 1055 configured to overlap with the first conductive semiconductor layer 1052, and disposed with the second conductive electrode 1056, and an active layer 1054 disposed between the first and second conductive semiconductor layers 1053, 1055.

Here, the first conductive type and the second conductive type may be composed of p-type and n-type, and vice versa. In addition, as described above, it may be a semiconductor light-emitting device without having the active layer.

Meanwhile, in the present disclosure, the first conductive electrode 1052 may be generated after the semiconductor light-emitting device is assembled to the wiring board by the self-assembly of the semiconductor light-emitting device. In addition, in the present disclosure, the second conductive electrode 1056 may include the magnetic body. The magnetic body may refer to a metal having magnetism. The magnetic body may be Ni, SmCo or the like, and for another example, a material corresponding to at least one of Gd-based, La-based, and Mn-based materials.

The magnetic body may be provided in the second conductive electrode 1056 in the form of particles. Furthermore, alternatively, for a conductive electrode including a magnetic body, a single layer of the conductive electrode may be made of a magnetic body. For such an example, as illustrated in FIG. 9, the second conductive electrode 1056 of the semiconductor light-emitting device 1050 may include a first layer 1056a and a second layer 1056b. Here, the first layer 1056a may be made to include a magnetic material, and the second layer 1056b may include a metal material other than the magnetic material.

As illustrated, in this example, the first layer 1056a including a magnetic body may be disposed to be in contact with the second conductive semiconductor layer 1055. In this case, the first layer 1056a is disposed between the second layer 1056b and the second conductive semiconductor layer 1055. The second layer 1056b may be a contact metal connected to the second electrode of the wiring substrate. However, the present disclosure is not necessarily limited thereto, and the magnetic body may be disposed on one surface of the first conductive semiconductor layer.

Referring again to FIGS. 6 and 7, more specifically, the self-assembly device may include a magnet handler that can be automatically or manually moved in the x, y, and z axes on the top of the fluid chamber or include a motor capable of rotating the magnet 163. The magnet handler and the motor may constitute the location controller 164. Through this, the magnet 163 rotates in a horizontal direction, a clockwise direction, or a counterclockwise direction with respect to the substrate 161.

On the other hand, a light transmitting bottom plate 166 may be formed in the fluid chamber 162, and the semiconductor light-emitting devices may be disposed between the bottom plate 166 and the substrate 161. An image sensor 167 may be positioned to view the bottom plate 166 so as to monitor an inside of the fluid chamber 162 through the bottom plate 166. The image sensor 167 is controlled by the controller 172, and may include an inverted type lens, a CCD, and the like to observe the assembly surface of the substrate 161.

The self-assembly device described above is configured to use a combination of a magnetic field and an electric field, and using those fields, the semiconductor light-emitting devices may be seated at preset positions of the substrate by an electric field in the process of being moved by a location change of the magnet. Hereinafter, an assembly process using the self-assembly device described above will be described in more detail.

First, a plurality of semiconductor light-emitting devices 1050 having magnetic bodies are formed through the process described with reference to FIGS. 5A to 5C. In this case, a magnetic body may be deposited on the semiconductor light-emitting device in the process of forming the second conductive electrode in FIG. 5C.

Next, the substrate 161 is transferred to the assembly position, and the semiconductor light-emitting devices 1050 are placed into the fluid chamber 162 (FIG. 8A).

As described above, the assembly position of the substrate 161 is a position at which the assembly surface on which the semiconductor light-emitting devices 1050 of the substrate 161 are assembled is disposed in a downward direction in the fluid chamber 162.

In this case, some of the semiconductor light-emitting devices 1050 may sink to the bottom of the fluid chamber 162 and some may float in the fluid. When the light transmitting bottom plate 166 is provided in the fluid chamber 162, some of the semiconductor light-emitting devices 1050 may sink to the bottom plate 166.

Next, a magnetic force is applied to the semiconductor light-emitting devices 1050 so that the semiconductor light-emitting devices 1050 float in the fluid chamber 162 in a vertical direction (FIG. 8B).

When the magnet 163 of the self-assembly device moves from its original position to an opposite side of the assembly surface of the substrate 161, the semiconductor light-emitting devices 1050 float in the fluid toward the substrate 161. The original position may be a position away from the fluid chamber 162. For another example, the magnet 163 may be composed of an electromagnet. In this case, electricity is supplied to the electromagnet to generate an initial magnetic force.

Meanwhile, in this example, a separation distance between the assembly surface of the substrate 161 and the semiconductor light-emitting devices 1050 may be controlled by adjusting the magnitude of the magnetic force. For example, the separation distance is controlled using the weight, buoyancy, and magnetic force of the semiconductor light-emitting devices 1050. The separation distance may be several millimeters to tens of micrometers from the outermost edge of the substrate.

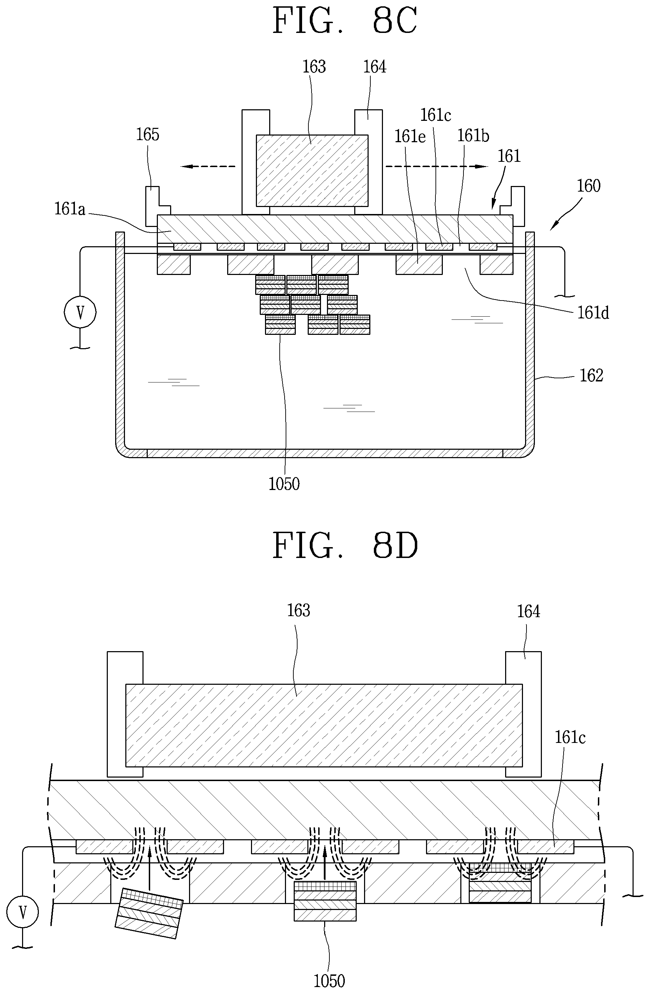

Next, a magnetic force is applied to the semiconductor light-emitting devices 1050 so that the semiconductor light-emitting devices 1050 move in one direction in the fluid chamber 162. For example, the magnet 163 moves in a horizontal direction, a clockwise direction or a counterclockwise direction with respect to the substrate (FIG. 8C). In this case, the semiconductor light-emitting devices 1050 move in a direction parallel to the substrate 161 at a position spaced apart from the substrate 161 by the magnetic force.

Next, the process of applying an electric field to guide the semiconductor light-emitting devices 1050 to preset positions of the substrate 161 so as to allow the semiconductor light-emitting devices 1050 to be seated at the preset positions during the movement of the semiconductor light-emitting devices 250 is carried out (FIG. 8C). For example, the semiconductor light-emitting devices 1050 move in a direction perpendicular to the substrate 161 by the electric field to be seated at preset positions of the substrate 161 while moving along a direction parallel to the substrate 161.

More specifically, electric power is supplied to a bi-planar electrode of the substrate 161 to generate an electric field to carry out assembly only at preset positions. In other words, the semiconductor light-emitting devices 1050 are assembled to the assembly position of the substrate 161 using a selectively generated electric field. For this purpose, the substrate 161 may include cells in which the semiconductor light-emitting devices 1050 are inserted.

Then, the unloading process of the substrate 161 is carried out, and the assembly process is completed. When the substrate 161 is an assembly substrate, a post-process of transferring the aligned semiconductor light-emitting devices to a wiring substrate as described above to implement a display apparatus may be carried out.

On the other hand, the semiconductor light-emitting devices 1050 may be guided to the preset positions, then the magnet 163 may move in a direction away from the substrate 161 such that the semiconductor light-emitting devices 1050 remaining in the fluid chambers 162 fall to the bottom of the fluid chambers 162, (FIG. 8D). For another example, if power supply is stopped when the magnet 163 is an electromagnet, then the semiconductor light-emitting devices 1050 remaining in the fluid chamber 162 fall to the bottom of the fluid chamber 162.

Then, when the semiconductor light-emitting devices 1050 on the bottom of the fluid chamber 162 are collected, the collected semiconductor light-emitting devices 1050 may be reused.

The above-described self-assembly device and method are characterized in that, in order to increase the assembly yield in a fluidic assembly, parts at a far distance are concentrated adjacent to a preset assembly site using a magnetic field, and a separate electric field is applied to the assembly site to selectively assemble the parts only in the assembly site. At this time, the assembly substrate is placed on an upper portion of the water tank and the assembly surface faces downward, thereby preventing nonspecific coupling while minimizing the effect of gravity due to the weight of parts. In other words, in order to increase the transfer yield, the assembly substrate is placed on the top to minimize the effect of a gravitational or frictional force, and prevent nonspecific coupling.

As described above, according to the present disclosure having the foregoing configuration, a large number of semiconductor light-emitting devices may be assembled at one time in a display apparatus in which individual pixels are formed with semiconductor light-emitting devices.

As described above, according to the present disclosure, a large number of semiconductor light-emitting devices may be pixelated on a wafer having a small size, and then transferred onto a large-area substrate. Through this, it may be possible to produce a large-area display apparatus at a low cost.

Meanwhile, the present disclosure provides a structure and method of an assembling substrate for increasing a yield of the foregoing self-assembly process and a yield subsequent to the self-assembly process. The present disclosure is limited to when the substrate 161 is used as an assembly substrate. In other words, the assembly substrate to be described later is not used as a wiring substrate of a display apparatus. Thus, hereinafter, the substrate 161 is referred to as an assembly substrate 161.

The present disclosure improves process yield from two perspectives. First, in the present disclosure, a strong electric field is formed to prevent a semiconductor light-emitting device from being seated at an undesired position due to a strong electric field formed at an undesired position. Second, the present disclosure prevents a semiconductor light-emitting device from remaining on the assembly substrate when transferring the semiconductor light-emitting devices seated on the assembly substrate to another substrate.

The foregoing solutions are not individually achieved by different components. The foregoing two solutions may be achieved by organically combining components to be described later with the assembly substrate 161 described above.

Prior to describing the present disclosure in detail, a post process for manufacturing a display apparatus subsequent to self-assembly will be described.

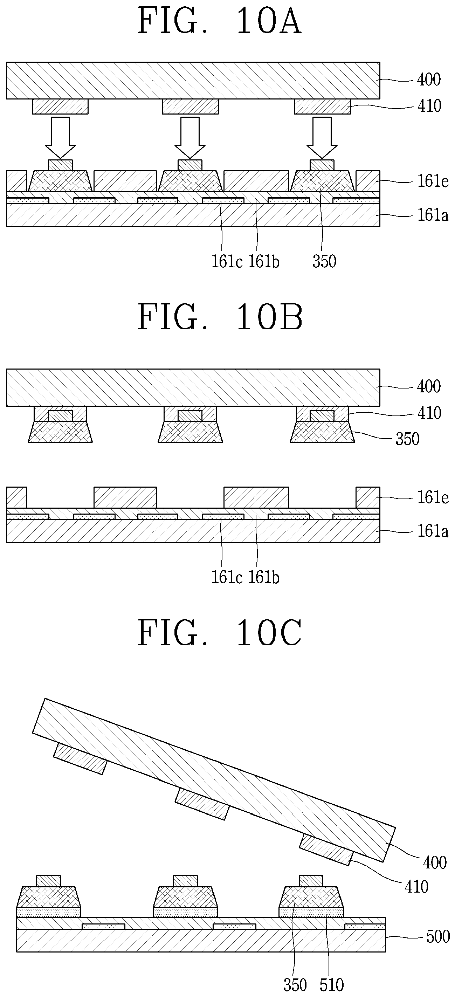

FIGS. 10A to 10C are conceptual views showing a state in which semiconductor light-emitting devices are transferred subsequent to a self-assembly process according to the present disclosure.

When the self-assembly process described with reference to FIGS. 8A to 8E is completed, the semiconductor light-emitting devices are seated at preset positions of the assembly substrate 161. The semiconductor light-emitting devices seated on the assembly substrate 161 are transferred to another substrate at least once. In the present specification, an embodiment in which the semiconductor light-emitting devices seated on the assembly substrate 161 are transferred twice, but the present disclosure is not limited thereto, and the semiconductor light-emitting devices seated on the assembly substrate 161 may be transferred to another substrate once or more than three times.

On the other hand, immediately after the self-assembly process is finished, an assembly surface of the assembly substrate 161 is in a state in which the assembly surface faces downward (or a gravity direction). For a process subsequent to self-assembly, the assembly substrate 161 may be turned over 180 degrees while the semiconductor light-emitting device is seated thereon. In this process, since there is a risk that the semiconductor light-emitting device may be released from the assembly substrate 161, a voltage must be applied to the plurality of electrodes 161c (hereinafter, assembly electrodes) while the assembly substrate 161 is turned over. An electric field formed between the assembly electrodes prevents the semiconductor light-emitting device from being released from the assembly substrate 161 while the assembly substrate 161 is turned over.

Subsequent to the self-assembly process, when the assembly substrate 161 is turned over 180 degrees, it becomes a shape as shown in FIG. 10A. Specifically, as shown in FIG. 10A, the assembly surface of the assembly substrate 161 is in a state that faces upward (or a direction opposite to gravity). In this state, a transfer substrate 400 is aligned on an upper side of the assembly substrate 161.

The transfer substrate 400 is a substrate for transferring the semiconductor light-emitting devices seated on the assembly substrate 161 to a wiring substrate by releasing them. The transfer substrate 400 may be formed of a PDMS (polydimethylsiloxane) material. Therefore, the transfer substrate 400 may be referred to as a PDMS substrate.

The transfer substrate 400 is aligned with the assembly substrate 161 and then pressed onto the assembly substrate 161. Then, when the transfer substrate 400 is transferred to an upper side of the assembly substrate 161, the semiconductor light-emitting devices 350 disposed on the assembly substrate 161 due to an adhesive force of the transfer substrate 400 are moved to the transfer substrate 400.

To this end, surface energy between the semiconductor light-emitting device 350 and the transfer substrate 400 must be higher than that between the semiconductor light-emitting device 350 and the dielectric layer 161b. The probability of releasing the semiconductor light-emitting device 350 from the assembly substrate 161 increases as a difference between surface energy between the semiconductor light-emitting device 350 and the transfer substrate 400 and surface energy between the semiconductor light-emitting device 350 and the dielectric layer 161b increases, and thus a larger difference between the two surface energies is preferable.

Meanwhile, the transfer substrate 400 may include a plurality of protruding portions 410 to allow a pressure applied by the transfer substrate 400 to be concentrated on the semiconductor light-emitting device 350 when the transfer substrate 400 is pressed against the assembly substrate 161. The protruding portions 410 may be disposed at the same interval as the semiconductor light-emitting devices seated on the assembly substrate 161. When the protruding portions 410 are aligned to overlap with the semiconductor light-emitting devices 350 and then the transfer substrate 400 is pressed against the assembly substrate 161, a pressure by the transfer substrate 400 may be concentrated on the semiconductor light-emitting devices 350. Through this, the present disclosure increases the probability that the semiconductor light-emitting device is released from the assembly substrate 161.

Meanwhile, while the semiconductor light-emitting devices are seated on the assembly substrate 161, part of the semiconductor light-emitting devices may be preferably exposed to an outside of the groove. When the semiconductor light-emitting devices 350 are not exposed to an outside of the groove, a pressure by the transfer substrate 400 is not concentrated on the semiconductor light-emitting devices 350, thereby reducing the probability of releasing the semiconductor light-emitting devices 350 from the assembly substrate 161

Finally, referring to FIG. 10C, pressing the transfer substrate 400 to a wiring substrate 500 to transfer the semiconductor light-emitting devices 350 from the transfer substrate 400 to the wiring substrate 500 is carried out. At this time, a protruding portion 510 may be formed on the wiring substrate 500. The transfer substrate 400 and the wiring substrate 500 are aligned so that the semiconductor light-emitting devices 350 disposed on the transfer substrate 400 overlap with the protruding portion 510. Then, when the transfer substrate 400 and the wiring substrate 500 are pressed, the probability of releasing the semiconductor light-emitting devices 350 from the transfer substrate 400 due to the protruding portion 510 may increase.

Meanwhile, in order for the semiconductor light-emitting devices 350 disposed on the transfer substrate 400 to be transferred to the wiring substrate 500, surface energy between the semiconductor light-emitting device 350 and the wiring substrate 500 must be higher than that between semiconductor light-emitting devices 350 and the transfer substrate 400. The probability of releasing the semiconductor light-emitting device 350 from the transfer substrate 400 increases as a difference between surface energy between the semiconductor light-emitting device 350 and the wiring substrate 500 and surface energy between the semiconductor light-emitting device 350 and the transfer substrate 400 increases, and thus a larger difference between the two surface energies is preferable.

Subsequent to transferring all of the semiconductor light-emitting devices 350 disposed on the transfer substrate 400 to the wiring substrate 500, forming an electrical connection between the semiconductor light-emitting devices 350 and the wiring electrodes formed on the wiring substrate 500 may be carried out. A structure of the wiring electrode and a method of forming an electrical connection may vary depending on the type of the semiconductor light-emitting devices 350.

Meanwhile, although not shown, an anisotropic conductive film may be disposed on the wiring substrate 500. In this case, an electrical connection may be formed between the semiconductor light-emitting devices 350 and the wiring electrodes formed on the wiring substrate 500 only by pressing the transfer substrate 400 and the wiring substrate 500.

Meanwhile, when manufacturing a display apparatus including semiconductor light-emitting devices emitting different colors, the methods described with reference to FIGS. 10A to 10C may be implemented in various ways. Hereinafter, a method of manufacturing a display apparatus including semiconductor light-emitting devices emitting red (R), green (G), and blue (B) will be described.

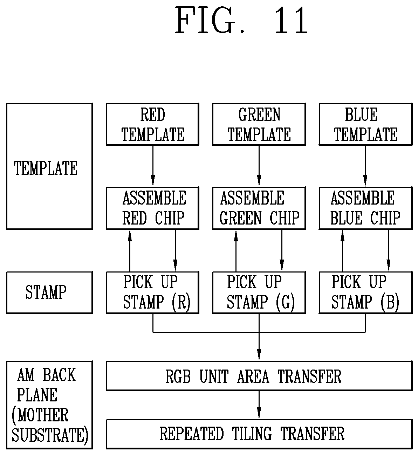

FIGS. 11 to 13 are flowcharts showing a method of manufacturing a display apparatus including semiconductor light-emitting devices emitting red (R), green (G), and blue (B) light.

Semiconductor light-emitting devices emitting different colors may be individually assembled on different assembly substrates. Specifically, the assembly substrate 161 may include a first assembly substrate on which semiconductor light-emitting devices emitting a first color are seated, a second assembly substrate on which semiconductor light-emitting devices emitting a second color different from the first color are seated, and a third assembly substrate on which semiconductor light-emitting devices emitting a third color different from the first color and the second color are seated. Different types of semiconductor light-emitting devices are assembled on each assembly substrate according to the method described with reference to FIGS. 8A to 8E. For example, semiconductor light-emitting devices emitting red (R), green (G), and blue (B) light, respectively, may be respectively assembled on first to third assembly substrates.

Referring to FIG. 11, each of a red chip, a green chip, and a blue chip may be assembled on each of first to third assembly substrates (a red template, a green template, and a blue template). In this state, each of the red, green, and blue chips may be transferred to a wiring substrate by a different transfer substrate.

Specifically, transferring semiconductor light-emitting devices seated on an assembly substrate to a wiring substrate includes pressing a first transfer substrate (stamp (R)) on the first assembly substrate (red template) to transfer semiconductor light-emitting devices (red chips) that emit the first color from the first assembly substrate (red template) to the first transfer substrate (stamp (R)), pressing a second transfer substrate (stamp (G)) on the second assembly substrate (green template) to transfer semiconductor light-emitting devices (green chips) that emit the second color from the second assembly substrate (green template) to the second transfer substrate (stamp (G)), and pressing a third transfer substrate (stamp (B)) on the third assembly substrate (blue template) to transfer semiconductor light-emitting devices (blue chips) that emit the third color from the third assembly substrate (blue template) to the third transfer substrate (stamp (B)).

Thereafter, pressing the first to third transfer substrates to the wiring substrate, respectively, and transferring the semiconductor light-emitting devices that emit the first to third colors from the first to third transfer substrates, respectively, to the wiring substrate is carried out.

According to the manufacturing method of FIG. 11, in order to manufacture a display apparatus including a red chip, a green chip, and a blue chip, three types of assembly substrates and three types of transfer substrates may be required.

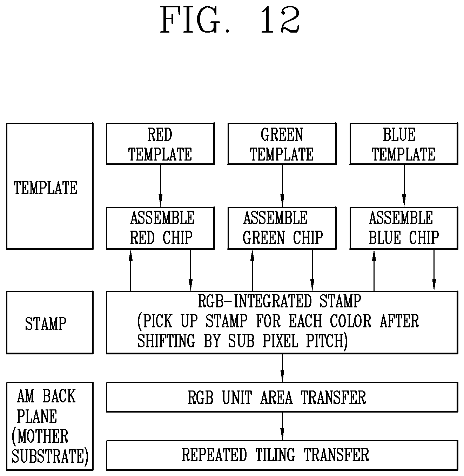

On the contrary, referring to FIG. 12, each of a red chip, a green chip, and a blue chip may be assembled on each of first to third assembly substrates (a red template, a green template, and a blue template). In this state, each of the red, green, and blue chips may be transferred to a wiring substrate by the same transfer substrate.

Specifically, transferring semiconductor light-emitting devices seated on the assembly substrate to a wiring substrate includes pressing a transfer substrate (RGB integrated stamp) on the first assembly substrate (red template) to transfer semiconductor light-emitting devices (red chips) that emit the first color from the first assembly substrate (red template) to the transfer substrate (RGB integrated stamp), pressing the transfer substrate (RGB integrated stamp) on the second assembly substrate (green template) to transfer semiconductor light-emitting devices (green chips) that emit the second color from the second assembly substrate (green template) to the transfer substrate (RGB integrated stamp), and pressing the transfer substrate (RGB integrated stamp) on the third assembly substrate (blue template) to transfer semiconductor light-emitting devices (blue chips) that emit the third color from the third assembly substrate (blue template) to the transfer substrate (RGB integrated stamp).

In this case, alignment positions between each of the first to third assembly substrates and the transfer substrate may be different from each other. For example, when alignment between the assembly substrate and the transfer substrate is completed, a relative position of the transfer substrate with respect to the first assembly substrate and a relative position of the transfer substrate with respect to the second assembly substrate may be different from each other. The transfer substrate may shift the alignment positions by a pitch of the sub-pixel whenever the type of assembly substrate is changed. When the transfer substrate is sequentially pressed onto the first to third assembly substrates through the foregoing method, all three types of chips may be transferred to the transfer substrate.

Then, as shown in FIG. 11, a process of pressing the transfer substrate to the wiring substrate to transfer the semiconductor light-emitting devices emitting first to third colors from the transfer substrate to the wiring substrate is carried out.

According to the manufacturing method of FIG. 12, in order to manufacture a display apparatus including a red chip, a green chip, and a blue chip, three types of assembly substrates and a single type of transfer substrate may be required.

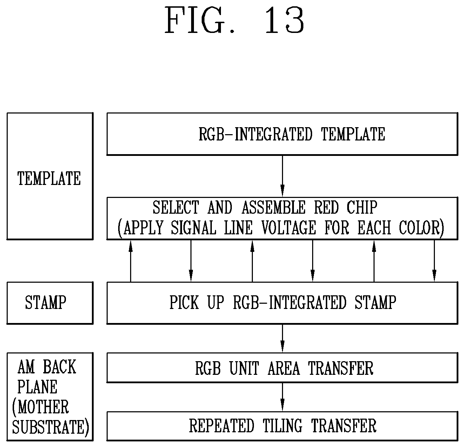

Contrary to FIGS. 11 and 12 described above, according to FIG. 13, a red chip, a green chip, and a blue chip may be respectively assembled on one assembly substrate (RGB integrated template). In this state, the red chip, green chip, and blue chip may be respectively transferred to the wiring substrate by the same transfer substrate (RGB integrated stamp).

According to the manufacturing method of FIG. 13, in order to manufacture a display apparatus including a red chip, a green chip, and a blue chip, a single type of assembly substrate and a single type of transfer substrate may be required.

When manufacturing a display apparatus including semiconductor light-emitting devices emitting different colors as described above, the manufacturing method may be implemented in various ways.

The present disclosure relates to a method of manufacturing a display apparatus including semiconductor light-emitting devices emitting light of different colors (hereinafter, semiconductor light-emitting devices emitting red, green, and blue light) and a substrate used therefor. Hereinafter, an embodiment of the present disclosure will be described with reference to the accompanying drawings.

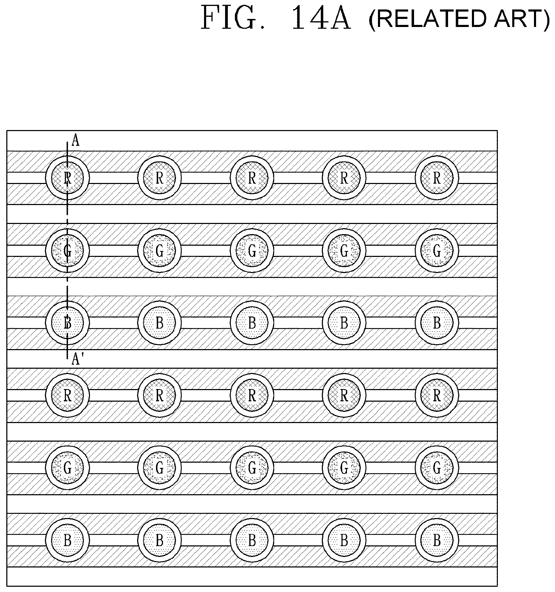

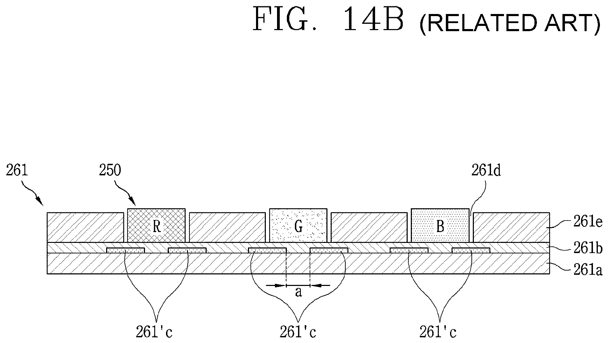

First, a method of manufacturing a display apparatus in the related art and a substrate structure used therefor will be described with reference to FIGS. 14A and 14B.

FIG. 14A is a view showing an embodiment of a substrate used for manufacturing a display apparatus in the related art, and FIG. 14B is a cross-sectional view taken along line A-A' of FIG. 14A.

In the present disclosure, a substrate used for manufacturing a display apparatus refers to a substrate (hereinafter, a donor substrate) to which semiconductor light-emitting devices are primarily transferred by the self-assembly method according to FIGS. 8A to 8E.

Referring to FIGS. 14A and 14B, a donor substrate 261 in the related art includes a plurality of cells 261d partitioned by a base portion 261a, a dielectric layer 261b, assembly electrodes 261c (261'c), and a partition wall 261e similar to the assembly substrate 161 as described above.

The assembly electrodes 261c to which a voltage is applied to form an electric field during self-assembly may be disposed on the base portion 261a. The assembly electrodes 261c may be line electrodes extending in one direction.

The plurality of cells 261d may be disposed to overlap the assembly electrodes 261c. In particular, the plurality of cells 261d are arranged to overlap two assembly electrodes 261c (hereinafter, referred to as pair electrodes 261c') disposed adjacent to each other, and an electric field may be formed inside the cells 261d as voltage is applied to the pair electrodes 261c', and thus the semiconductor light-emitting devices 250 may be seated into the cells 261d by dielectrophoresis (DEP).

The plurality of cells 261d are arranged in a plurality of columns and rows, and the semiconductor light-emitting devices 250 emitting light of the same color may be seated into the cells 261d arranged in the same column or row, respectively. In this case, a column or a row may refer to an extension direction of the assembly electrodes 261c. That is, the semiconductor light-emitting devices 250 emitting light of the same color may be seated into the cells 261d arranged along the extension direction of the assembly electrodes 261c. Meanwhile, the semiconductor light-emitting devices 250 emitting light of different colors may be seated into the cells 261d arranged along the same row or column, respectively. That is, the semiconductor light-emitting devices 250 emitting light of different colors may be seated into the cells 261d arranged along a direction crossing the extension direction of the assembly electrodes 261c (preferably, a vertical direction).

Meanwhile, in the related art, in order to manufacture a display apparatus including semiconductor light-emitting devices emitting light of different colors, self-assembly has been carried out for semiconductor light-emitting devices emitting light of the same color. In detail, applying a voltage to pair electrodes overlapping the cells on which semiconductor light-emitting devices emitting red light (hereinafter, red semiconductor light-emitting devices) are seated in order to seat the red semiconductor light-emitting devices on the cells, applying a voltage to pair electrodes overlapping the cells on which semiconductor light-emitting devices emitting green light (hereinafter, green semiconductor light-emitting devices) are seated in order to seat the green semiconductor light-emitting devices on the cells, and applying a voltage to pair electrodes overlapping the cells on which semiconductor light-emitting devices emitting blue light (hereinafter, blue semiconductor light-emitting devices) are seated in order to seat the blue semiconductor light-emitting devices on the cells have been sequentially carried out.

Alternatively, semiconductor light-emitting devices emitting light of different colors have been designed in different shapes, and self-assemblies on the semiconductor light-emitting devices emitting light of different colors have been simultaneously carried out.

However, according to the related art, a voltage signal having the same frequency has been applied to all pair electrodes to form an electric field, and there has been a problem in that a color mixture (e.g., when a red semiconductor light-emitting device is assembled to a cell on which a green light-emitting device is seated), which has caused a reduction in assembly rate.

In order to solve this problem, the present disclosure proposes a method of manufacturing a display apparatus including a donor substrate having an electric field gradient and red, green and blue semiconductor light-emitting devices using the donor substrate.

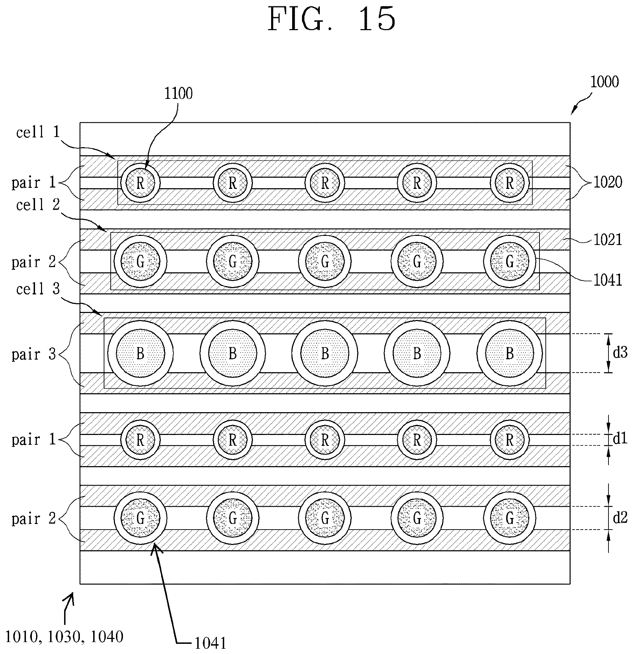

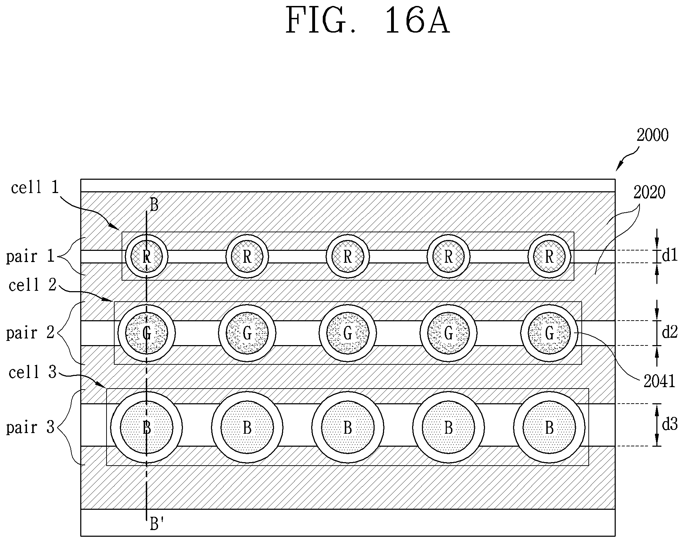

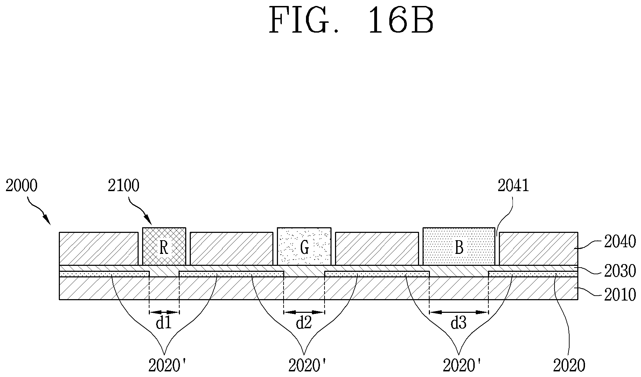

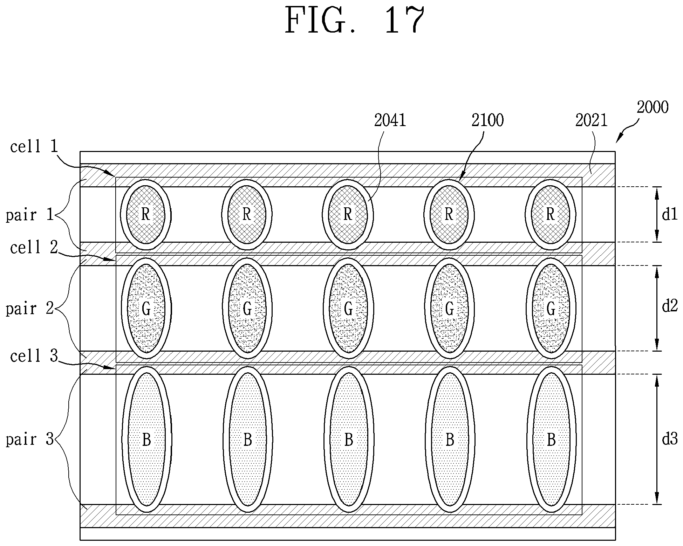

FIG. 15 is a view showing an embodiment of a substrate used for manufacturing a display apparatus according to the present disclosure, which is an embodiment of the invention, and FIGS. 16A, 16B and 17 are views showing other embodiments of a substrate used for manufacturing a display apparatus according to the present disclosure, which are embodiments of the invention.

According to the present disclosure, a donor substrate 1000 (2000) may include a base portion 1010 (2010), pair electrodes 1020 (2020 or 2020'), a dielectric layer 1030 (2030), a partition wall portion 1040 (2040), and cells 1041 (2041) disposed (or partitioned) by the partition wall portion 1040 (2040). In describing the donor substrate 1000 (2000) according to the present disclosure, a redundant description of a structure of the assembly substrate 161 and the donor substrate 261 in the related art will be omitted.

The base portion 1010 (2010) may include an insulating material. For example, the base portion 1010 (2010) may include a polymer material such as glass, quartz, or polyimide (PI), and may be a rigid substrate or a flexible substrate depending on the material.

The pair electrodes 1020 (2020) may be disposed on the base portion 1010 (2010). The pair electrodes 1020 (2020) may be composed of two assembly electrodes 1021 (2021) in the form of a line extending in one direction, and a voltage for forming an electric field may be applied thereto. The pair electrodes 1020 (2020) may be formed of one or two or more of non-resistive metals such as Ag, Al, Mo, Ti, and Cu to transmit a voltage signal.

According to the present disclosure, in order for the donor substrate 1000 (1000) to have an electric field gradient, the pair electrodes 1020 (2020) may be disposed on the base portion 1010 (2010) at different intervals. A detailed description related thereto will be provided later.

Furthermore, the dielectric layer 1030 (2030) may be disposed on the base portion 1010 (2010) to cover the pair electrodes 1020 (2020). Since the dielectric layer 1030 (2030) is formed of an inorganic insulating material having a high dielectric constant, such as SiO₂, SiNx, Al₂O₃, TiO₂, and HfO₂, the semiconductor light-emitting devices 1100 (2100) may behave in a fluid by dielectrophoresis during self-assembly. The dielectric layer 1030 (2030) may be formed at a thickness of several tens of nm to several µm.

The partition wall portion 1040 (2040) may be disposed on the dielectric layer 1030 (2030). The partition wall portion 1040 (2040) may be formed of an inorganic insulating material having a high dielectric constant, such as SiO₂, SiNx, Al₂O₃, TiO₂, and HfO₂, or a polymer material, and the dielectric layer 1030 (2030) and the partition wall portion 1040 (2040) may be formed of the same material. The partition wall portion 1040 (2040) may be formed at a thickness of several to several tens of µm.

Specifically, the partition wall portion 1040 (2040) may be disposed on the dielectric layer 1030 (2030) while constituting the plurality of cells 1041 (2041). The cells 1041 (2041) may be arranged along an extension direction of the assembly electrodes 1020 (2020) and may be disposed in a matrix arrangement. Furthermore, the cells 1041 (2041) may be arranged to overlap the pair electrodes 1020 (2020), and as a voltage is applied to the pair electrodes 1020 (2020), an electric field may be formed inside the cells 1041 (2041), and the semiconductor light-emitting devices 1100 (2100) may be seated thereon. In addition, the cells 1041 (2041) may be formed in shapes corresponding to the semiconductor light-emitting devices 1100 (2100) seated on the cells 1041 (2041).

Meanwhile, as described above, the pair electrodes 1020 (2020) may be disposed at different intervals on the donor substrate 1000 (2000) according to the present disclosure. Referring to FIGS. 15 to 17, the pair electrodes 1020 (2020) may include first pair electrodes (pair 1) disposed at a first interval d1, and second pair electrodes (pair 2) disposed at a second interval d2, and third pair electrodes (pair 3) disposed at a third interval d3, and the first pair electrodes (pair 1), the second pair electrodes (pair 2), and the third pair electrodes (pair 3) may be electrodes for assembling the semiconductor light-emitting devices 1100 (2100) emitting light of different colors as shown in the drawing.

An interval between the pair electrodes 1020 (2020) may affect the strength of an electric field formed by the pair electrodes 1020 (2020). In detail, an electric field with a high strength may be formed as the interval between the pair electrodes 1020 (2020) is decreased, and an electric field with a low strength may be formed as the interval between the pair electrodes 1020 (2020) is increased. Accordingly, in the drawing, the strength of an electric field formed by the first pair electrodes (pair 1) is higher than the strength of an electric field formed by the second pair electrodes (pair 2) and the third pair electrodes (pair 3), and in particular, the strength of the electric field formed by the third pair of electrodes (pair 3) may be the lowest.

In addition, in order to define a unit pixel, the first pair electrodes (pair 1), the second pair electrodes (pair 2), and the third pair electrodes (pair 3) configured to assemble the semiconductor light-emitting devices emitting light of different colors may be alternately arranged. At this time, the individual assembled electrode 1021 may be involved only in the formation of one pair electrode 1020 as shown in FIG. 15 or involved in the formation of two pair electrodes 2020 (i.e., one assembly electrode 2021 may be shared between the two pair electrodes 2020 disposed adjacent to each other) as shown in FIGS. 16 and 17.

Furthermore, according to the present disclosure, the cells 1041 (2041) overlapping the pair electrodes 1020 (2020) may have different shapes (a concept including size) according to an interval between the pair electrodes 1020 (2020). As shown in FIGS. 15 to 17, the cells 1041 (2041) may include first cells (cell 1) having a first shape to overlap the first pair electrodes (pair 1), second cells (cell 2) having a second shape to overlap the second pair electrodes (pair 2), and third cells (cell 3) having a third shape to overlap the third pair electrodes (pair 3). For example, the cells 1041 (2041) may be defined in a circular shape, an oval shape, or a rod shape.

Referring to the drawings, the first to third cells (cell 1, cell 2, and cell 3) may be defined in different sizes according to an arrangement interval of the pair electrodes 1020 (2020), and a size of the first cells (cell 1) may be the smallest, and a size of the third cells (cell 3) may be the largest. In addition, the semiconductor light-emitting devices 1100 (2100) emitting light of different colors may be seated on the first to third cells (cell 1, cell 2, and cell 3), and accordingly, a red semiconductor light-emitting device, a green semiconductor light-emitting device, and a blue light-emitting device may be defined in a shape corresponding to any one of the first to third cells, respectively.

According to the present disclosure, since the first cells (cell 1), the second cells (cell 2), and the third cells (cell 3) overlap the pair electrodes 1020 (2020) arranged at different intervals, electric fields with different strengths may be formed inside the respective cells 1041 (2041). At this time, sizes of the semiconductor light-emitting devices 1100 (2100) may have a compensatory relationship with dielectrophoresis according to an interval between the pair electrodes 1020 (2020), and therefore, the self-assembly of the semiconductor light-emitting devices 1100 (2100) using electric fields may be carried out.

Meanwhile, in order for the donor substrate 1000 (2000) to have an electric field gradient, in addition to disposing the pair electrodes 1020 (2020) at different intervals, the material and/or thickness of the dielectric layer 1030 (2030) and/or the partition wall portion 1040 (2040) may be configured in different ways to control the dielectric constant.

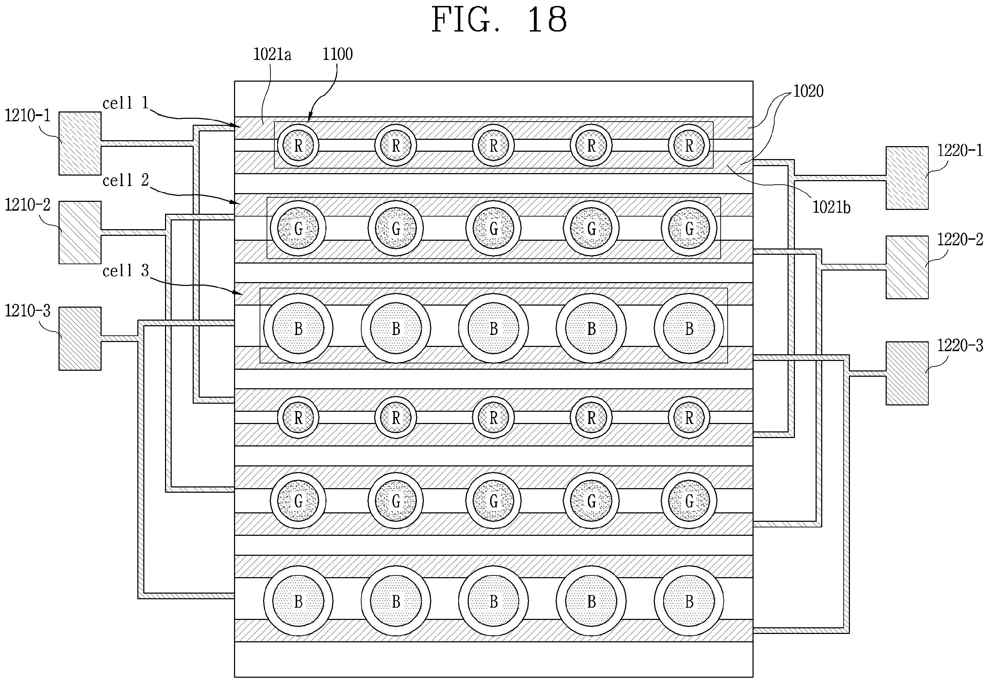

Meanwhile, according to the present disclosure, the semiconductor light-emitting devices emitting light of different colors may be self-assembled at different frequencies. Hereinafter, a structure related thereto will be described with reference to FIG. 18.

FIG. 18 is a view showing a structure in which an electrode pad is connected to the substrate according to FIG. 15.

Referring to FIG. 18, the donor substrate 1000 may further include electrode pads for applying a voltage to the pair electrodes 1020. For example, the electrode pads 1200 may be disposed on both ends of the donor substrate 1000. The electrode pad 1200 may include a first electrode pad 1210 connected to either one electrode 1021a of the pair electrodes 1020 to apply a first signal thereto, and a second electrode pad 1220 connected to the other one electrode 1021b of the pair electrodes 1020 to apply a second signal thereto. The first signal applied from the first electrode pad 1210 and the second signal applied from the second electrode pad 1220 may be signals having different polarities, and thus an AC voltage at a predetermined frequency may be applied to the pair electrodes 1020. The polarities of the first signal and the second signal may be varied.

The first electrode pad 1210 and the second electrode pad 1220 may be provided in plurality to be connected for each group of pair electrodes. That is, as shown in FIG. 18, the first electrode pad 1210 and the second electrode pad 1220 may include pads 1210-1, 1220-1 connected to the first pair electrodes (pair 1), pads 1210-2, 1220-2 connected to the second pair electrodes (pair 2), and pads 1210-3, 1220-3 connected to the third pair electrodes (pair 3), and the first pair electrodes (pair 1), the second pair electrodes (pair 2), and the third pair electrodes (pair 3) may be connected to respective electrode pads through bus lines.

As described above, since the electrode pads are connected for each group of pair electrodes, frequencies of a voltage applied to each group of pair electrodes may be separated. In the present disclosure, the semiconductor light-emitting devices 1100 may be assembled for each separated frequency using semiconductor light-emitting devices (n-DEP and p-DEP) having different dielectrophoretic characteristics.

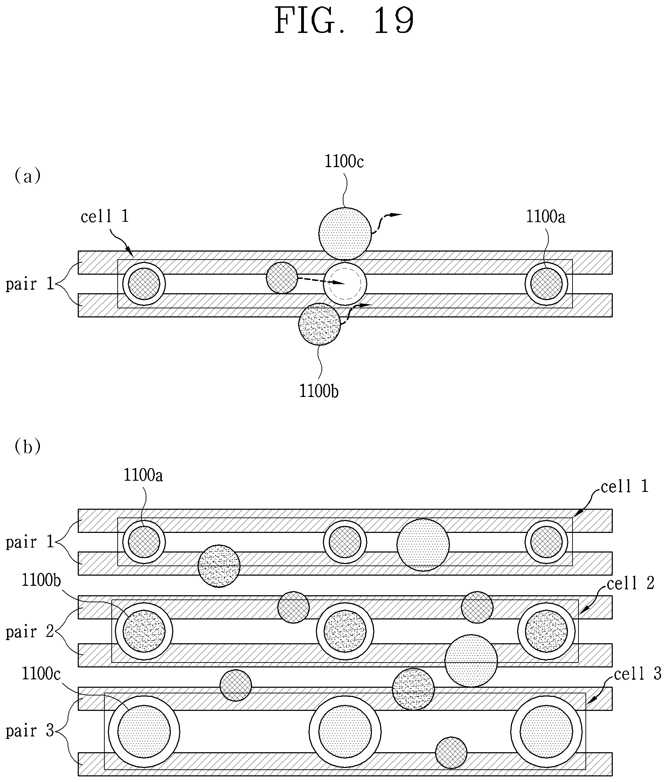

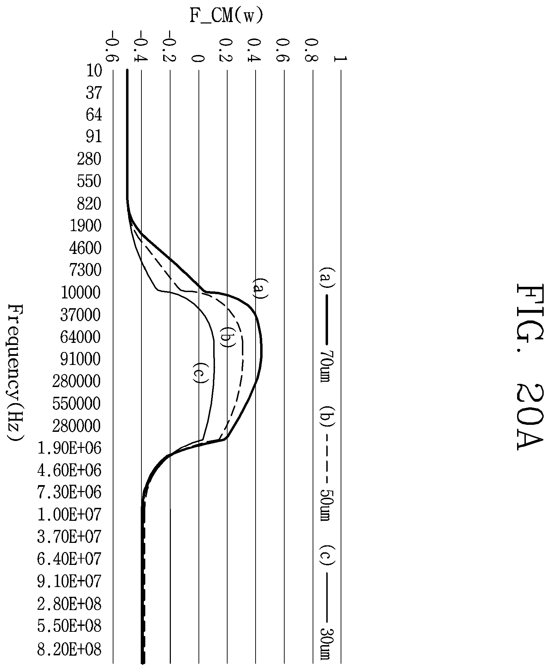

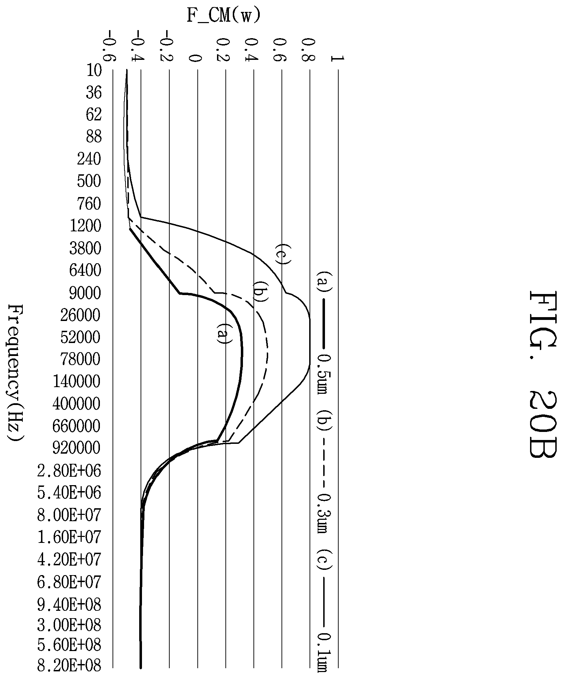

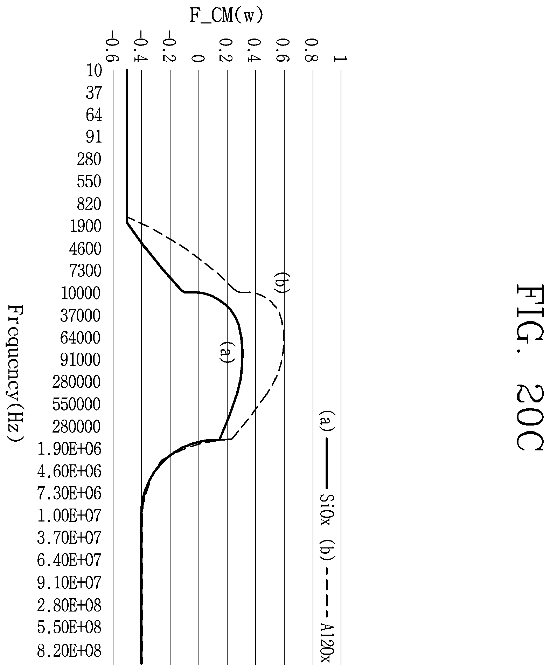

Hereinafter, a method for manufacturing a display apparatus according to the present disclosure, which is an embodiment of the invention, will be described with reference to FIGS. 19 and 20.

FIG. 19 is a view showing a method of manufacturing a display apparatus according to the present disclosure, and FIGS. 20A to 20C are graphs showing assembly frequency characteristics of semiconductor light-emitting devices according to various embodiments of the present disclosure.

According to the present disclosure, a self-assembly method using an electric field and a magnetic field in a fluid shown in FIGS. 8A to 8E is used to manufacture a display apparatus. However, the donor substrate 1000 described above may be used for an assembly substrate, and thus some steps may be changed.

According to the present disclosure, in order to manufacture a display apparatus, first, steps of placing the semiconductor light-emitting devices 1100 into a chamber containing a fluid, and transferring the donor substrate 1000 including the pair electrodes 1020 to which a voltage for forming an electric field is applied and the cells 1041 on which the semiconductor light-emitting devices 1100 are seated to an assembly position may be performed. In one embodiment, the fluid contained in the chamber may be water, preferably de-ionized water (DI water), and the donor substrate 1000 may be disposed at an upper side of the chamber to minimize the influence of gravity and frictional force.

According to the present disclosure, the semiconductor light-emitting devices 1100 having different dielectrophoretic characteristics may be placed into the chamber containing the fluid. That is, the semiconductor light-emitting devices 1100n having n-DEP characteristics and the semiconductor light-emitting devices 1100p having p-DEP characteristics may be placed into the fluid chamber. In addition, according to the present disclosure, in order to manufacture a display apparatus including semiconductor light-emitting devices emitting light of different colors, red semiconductor light-emitting devices, green semiconductor light-emitting devices and blue semiconductor light-emitting devices may be placed into a chamber containing a fluid, and semiconductor light-emitting devices emitting light of the same color may have the same dielectrophoretic characteristics. A detailed description related thereto will be provided later.

Next, a step of applying a magnetic force to the semiconductor light-emitting devices 1100 that have been placed into the chamber containing the fluid to move the semiconductor light-emitting devices along one direction may be performed. This step is the same as that described above, and thus a detailed description thereof will be omitted.

Next, a step of forming an electric field on the donor substrate 1000 may be performed such that the moving semiconductor light-emitting devices 1100 are seated on the cells 1041. This step may be performed by applying a voltage to the pair electrodes 1020 disposed on the donor substrate 1000. Specifically, the first pair electrodes (pair 1) having a first interval d1, the second pair electrodes (pair 2) having a second interval d2, and the third pair electrodes (pair 3) having a third interval d3 may be disposed on the donor substrate 1000, and the first to third pairs electrodes may be used to assemble semiconductor light-emitting devices emitting light of different colors.

According to the present disclosure, different voltages may be applied to the first to third pair electrodes, respectively, and the different voltages may refer to alternating voltages having different frequencies. For example, a voltage having a first frequency may be applied to the first pair electrodes (pair 1), a voltage having a second frequency may be applied to the second pair electrodes (pair 2), and a voltage having a third frequency may be applied to the third pair electrodes (pair 3). In this case, the first to third frequencies may refer to different frequency ranges. A voltage having a similar frequency band may be applied to some of the first to third pair electrodes. That is, in the present disclosure, the semiconductor light-emitting devices emitting light of different colors may be assembled at different frequencies.

According to the present disclosure, the donor substrate 1000 may include first cells (cell 1) having a first shape to overlap the first pair electrodes (pair 1), second cells (cell 2) having a second shape to overlap the second pair electrodes (pair 2), and third cells (cell 3) having a third shape to overlap the third pair electrodes (pair 3). The semiconductor light-emitting devices 1100 may include first semiconductor light-emitting devices 1100a having a first shape, second semiconductor light-emitting devices 1100b having a second shape, and third semiconductor light-emitting devices 1100c having a third shape, and the first to third semiconductor light-emitting devices may be seated on first to third cells defined in corresponding shapes, respectively. The first to third semiconductor light-emitting devices may correspond to semiconductor light-emitting devices emitting light of different colors.

In summary, in the method for manufacturing a display apparatus according to the present disclosure, red, green, and blue semiconductor light-emitting devices may be seated on cells having shapes corresponding to those of the semiconductor light-emitting devices at voltages having different frequencies.

Meanwhile, according to the present disclosure, the semiconductor light-emitting devices 1100 having different dielectrophoretic characteristics may be used to allow the semiconductor light-emitting devices 1100 to be seated on the cells 1041 according to frequencies. The dielectrophoretic characteristics of the semiconductor light-emitting devices 1100 may be determined by the volume, electrical conductivity, dielectric constant, and the like of the semiconductor light-emitting devices. Among them, the electrical conductivity and dielectric constant may be determined as relative values with regard to a medium, i.e., a fluid contained in a chamber.

In one embodiment, semiconductor light-emitting devices having higher electrical conductivity and lower dielectric constant than the fluid and semiconductor light-emitting devices having lower electrical conductivity and higher dielectric constant than the fluid may be placed into the chamber containing the fluid, the semiconductor light-emitting devices corresponding to the latter may be disposed to have a larger volume than those corresponding to the former. In another embodiment, the semiconductor light-emitting devices 1100 may include a passivation layer covering surfaces thereof, and semiconductor light-emitting devices in which at least one of a thickness and a material of the passivation layer is different may be placed into the chamber containing the fluid to allow the semiconductor light-emitting devices 1100 to have a dielectric constant difference.

According to embodiments of the semiconductor light-emitting devices, any one semiconductor light-emitting device having p-DEP characteristics moves toward a strong electric field to be seated on the cells 1041 and the other one having n-DEP characteristics is not seated on the cells 1041 in a voltage signal having a predetermined frequency range. Accordingly, it may be possible to selectively assemble some semiconductor light-emitting devices 1100 at a specific frequency. Meanwhile, the dielectrophoretic characteristics of the semiconductor light-emitting devices may be different as the frequency range of the voltage signal is changed.

Referring to FIG. 19, when a voltage having a first frequency (e.g., a high-frequency band of 20 kHz or more) is applied to the first pair electrodes (pair 1), the first semiconductor light-emitting devices 1100a may be allowed to have p-DEP characteristics so as to be seated on the first cells (cell 1), and the second and third semiconductor light-emitting devices 1100b, 1100c may be allowed to have n-DEP characteristics so as not to be seated on the first cells (cell 1). On the other hand, when voltages having a second frequency and a third frequency (e.g., a low frequency band of 3 kHz or less) are applied to the second pair electrodes (pair 2) and the third pair electrodes (pair 3), respectively, the second and third semiconductor light-emitting devices 1100b, 1100c may be allowed to have p-DEP characteristics to be seated on the second cells (cell 2) and the third cells (cell 3), and the first semiconductor light-emitting devices 1100a may be allowed to have n-DEP characteristics so as not to be seated on the second and third cells (cell 2, cell 3). In addition, the second and third semiconductor light-emitting devices 1100b, 1100c may be guided and seated at preset positions according to a volume of the semiconductor light-emitting devices and an interval between the pair electrodes.

FIGS. 20A to 20C are graphs showing assembly frequency characteristics according to various structures of semiconductor light-emitting devices. FIG. 20A shows assembly frequency characteristics according to a volume of the semiconductor light-emitting device, in which the assembly frequency may shift to a lower frequency band as the volume of the semiconductor light-emitting device increases. FIG. 20B shows assembly frequency characteristics according to a thickness of the passivation layer of the semiconductor light-emitting device, in which the assembly frequency may shift to a lower frequency band as the thickness of the passivation layer increases. FIG. 20C shows frequency characteristics according to a material of the passivation layer of the semiconductor light-emitting device, in which the assembly frequency may shift to a low frequency band when the passivation layer is formed of a material having a high dielectric constant.

The present disclosure described above will not be limited to configurations and methods according to the above-described embodiments, and all or part of each embodiment may be selectively combined and configured to make various modifications thereto. The invention is defined by the appended claims.

## Claims

1. A substrate for manufacturing a display apparatus, the substrate (1000) comprising:
a base portion (1010);
pair electrodes (1020) disposed on the base portion (1010) to extend in an extension direction;
a dielectric layer (1030) disposed on the base portion (1010) to cover the pair electrodes (1020);
a partition wall portion (1040) disposed on the dielectric layer (1030); and
cells (1041) defined by the partition wall portion (1040), and arranged to overlap the pair electrodes (1020) along the extension direction of the pair electrodes (1020),
wherein the pair electrodes (1020) are arranged at different intervals,
wherein the substrate further comprises:
an electrode pad (1200) that is configured to apply a voltage to the pair electrodes (1020),
wherein the electrode pad (1200) comprises:
a first electrode pad (1210) connected to one electrode of the pair electrodes (1020) to apply a first signal thereto; and
a second electrode pad (1220) connected to another electrode of the pair electrodes (1020) to apply a second signal thereto,
**characterised in that**
the voltage is a plurality of different alternating voltages having different frequencies that are respectively applied to the pair electrodes.

2. The substrate of claim 1, wherein the pair electrodes (1020) comprise:
first pair electrodes disposed at first intervals;
second pair electrodes disposed at second intervals; and
third pair electrodes disposed at third intervals.

3. The substrate of claim 2, wherein the cells (1041) comprise:
first cells having a first shape to overlap the first pair electrodes;
second cells having a second shape to overlap the second pair electrodes; and
third cells having a third shape to overlap the third pair electrodes.

4. The substrate of any one of claims 2 and 3, wherein the first pair electrodes, the second pair electrodes, and the third pair electrodes are alternately disposed on the base portion (1010).

5. The substrate of claim 4, wherein the pair electrodes (1020) comprise first pair electrodes disposed at first intervals, second pair electrodes disposed at second intervals, and third pair electrodes disposed at third intervals, and
wherein the first pair of electrodes, the second pair electrodes, and the third pair electrodes are respectively connected to different first and second electrode pads (1210, 1220).

6. A method for manufacturing a display apparatus, the method comprising:
placing semiconductor light-emitting devices (1100) into a chamber containing a fluid, and transferring a substrate (1000) comprising cells (1041) on which the semiconductor light-emitting devices (1100) are to be seated to an assembly position;
applying a magnetic force to the semiconductor light-emitting devices (1100) to move the semiconductor light-emitting devices (1100) in one direction; and
forming an electric field on the substrate (1000) to allow the moving semiconductor light-emitting devices (1100) to be seated on the cells (1041),
wherein the substrate (1000) comprises first pair electrodes disposed at first intervals, second pair electrodes disposed at second intervals, and third pair electrodes disposed at third intervals, and
wherein different voltages are respectively applied to the first pair electrodes, the second pair electrodes, and the third pair electrodes to form electric fields on the substrate (1000), and
**characterised in that**
the different voltages include alternating voltages having different frequencies that are respectively applied to the first pair electrodes, the second pair electrodes, and the third pair electrodes.

7. The method of claim 6, wherein the cells (1041) comprise first cells having a first shape to overlap the first pair electrodes, second cells having a second shape to overlap the second pair electrodes, and third cells having a third shape to overlap the third pair electrodes.

8. The method of claim 6 or 7, wherein the semiconductor light-emitting devices (1100) comprise first semiconductor light-emitting devices (1100a) having a first shape, second semiconductor light-emitting devices (1100b) having a second shape, and third semiconductor light-emitting devices (1100c) having a third shape, and
wherein the first semiconductor light-emitting devices (1100a), the second semiconductor light-emitting devices (1100b) and the third semiconductor light-emitting devices (1100c) are semiconductor light-emitting devices (1100) emitting light of different colors.

9. The method of any one of claims 6 to 8, wherein the semiconductor light-emitting devices (1100) comprise first semiconductor light-emitting devices (1100a) having a higher electrical conductivity and a lower dielectric constant than the fluid, and second semiconductor light-emitting devices (1100b) having a lower electrical conductivity and a higher dielectric constant than the fluid.

10. The method of any one of claims 6 to 9, wherein the semiconductor light-emitting devices (1100) comprise a passivation layer disposed to cover surfaces of the semiconductor light-emitting devices (1100), and
wherein the semiconductor light-emitting devices (1100) comprise semiconductor light-emitting devices (1100) in which at least one of a thickness and a material of the passivation layer is different than that of other semiconductor light-emitting devices (1100).

## Patentansprüche

1. Substrat zur Herstellung einer Anzeigevorrichtung, wobei das Substrat (1000) aufweist:
einen Basisabschnitt (1010);
Paarelektroden (1020), die auf dem Basisabschnitt (1010) so angeordnet ist, dass sie sich in einer Erstreckungsrichtung erstrecken;
eine dielektrische Schicht (1030), die auf dem Basisabschnitt (1010) so angeordnet ist, dass sie die Paarelektroden (1020) bedeckt;
einen Trennwandabschnitt (1040), der auf der dielektrischen Schicht (1030) angeordnet ist; und
Zellen (1041), die durch den Trennwandabschnitt (1040) definiert und so angeordnet sind, dass sie die Paarelektroden (1020) entlang der Erstreckungsrichtung der Paarelektroden (1020) überlappen,
wobei die Paarelektroden (1020) in unterschiedlichen Intervallen angeordnet sind,
wobei das Substrat ferner aufweist:
ein Elektrodenpad (1200), das konfiguriert ist, eine Spannung an die Paarelektroden (1020) anzulegen,
wobei das Elektrodenpad (1200) aufweist:
ein erstes Elektrodenpad (1210), das mit einer Elektrode der Paarelektroden (1020) verbunden ist, um ein erstes Signal daran anzulegen; und
ein zweites Elektrodenpad (1220), das mit einer anderen Elektrode der Paarelektroden (1020) verbunden ist, um ein zweites Signal daran anzulegen,
**dadurch gekennzeichnet, dass**
es sich bei der Spannung um mehrere unterschiedliche Wechselspannungen mit unterschiedlichen Frequenzen handelt, die jeweils an die beiden Elektroden angelegt werden.

2. Substrat nach Anspruch 1, wobei die Paarelektroden (1020) aufweisen:
erste Paarelektroden, die in ersten Intervallen angeordnet sind;
zweite Paarelektroden, die in zweiten Intervallen angeordnet sind; und
dritte Paarelektroden, die in dritten Intervallen angeordnet sind.

3. Substrat nach Anspruch 2, wobei die Zellen (1041) aufweisen:
erste Zellen mit einer ersten Form, um die ersten Paarelektroden zu überlappen;
zweite Zellen mit einer zweiten Form, um die zweiten Paarelektroden zu überlappen; und
dritte Zellen mit einer dritten Form, um die dritten Paarelektroden zu überlappen.

4. Substrat nach einem der Ansprüche 2 und 3, wobei die ersten Paarelektroden, die zweiten Paarelektroden und die dritten Paarelektroden abwechselnd auf dem Basisabschnitt (1010) angeordnet sind.

5. Substrat nach Anspruch 4, wobei die Paarelektroden (1020) erste Paarelektroden, die in ersten Intervallen angeordnet sind, zweite Paarelektroden, die in zweiten Intervallen angeordnet sind, und dritte Paarelektroden aufweisen, die in dritten Intervallen angeordnet sind, und
wobei die ersten Paarelektroden, die zweiten Paarelektroden und die dritten Paarelektroden jeweils mit unterschiedlichen ersten und zweiten Elektrodenpads (1210, 1220) verbunden sind.

6. Verfahren zur Herstellung einer Anzeigevorrichtung, wobei das Verfahren aufweist:
Anordnen von lichtemittierenden Halbleitervorrichtungen (1100) in einer Kammer, die ein Fluid enthält, und Überführen eines Substrats (1000), das Zellen (1041) aufweist, auf die die lichtemittierenden Halbleitervorrichtungen (1100) aufgesetzt werden sollen, in eine Montageposition;
Anwenden einer Magnetkraft auf die lichtemittierenden Halbleitervorrichtungen (1100), um die lichtemittierenden Halbleitervorrichtungen (1100) in eine Richtung zu bewegen; und
Bilden eines elektrischen Feldes auf dem Substrat (1000), um zu ermöglichen, dass die sich bewegenden lichtemittierenden Halbleitervorrichtungen (1100) auf die Zellen (1041) aufgesetzt werden,
wobei das Substrat (1000) erste Paarelektroden, die in ersten Intervallen angeordnet sind, zweite Paarelektroden, die in zweiten Intervallen angeordnet sind, und dritte Paarelektroden aufweist, die in dritten Intervallen angeordnet sind, und wobei
unterschiedliche Spannungen jeweils an die ersten Paarelektroden, die zweiten Paarelektroden und die dritten Paarelektroden angelegt werden, um elektrische Felder auf dem Substrat (1000) zu bilden, und
**dadurch gekennzeichnet, dass**
die unterschiedlichen Spannungen Wechselspannungen mit unterschiedlichen Frequenzen aufweisen, die jeweils an die ersten Paarelektroden, die zweiten Paarelektroden und die dritten Paarelektroden angelegt werden.

7. Verfahren nach Anspruch 6, wobei die Zellen (1041) erste Zellen mit einer ersten Form, um die ersten Paarelektroden zu überlappen, zweite Zellen mit einer zweiten Form, um die zweiten Paarelektroden zu überlappen, und dritte Zellen mit einer dritten Form aufweisen, um die dritten Paarelektroden zu überlappen.

8. Verfahren nach Anspruch 6 oder 7, wobei die lichtemittierenden Halbleitervorrichtungen (1100) erste lichtemittierende Halbleitervorrichtungen (1100a) mit einer ersten Form, zweite lichtemittierende Halbleitervorrichtungen (1100b) mit einer zweiten Form und dritte lichtemittierende Halbleitervorrichtungen (1100c) mit einer dritten Form aufweisen, und
wobei die ersten lichtemittierenden Halbleitervorrichtungen (1100a), die zweiten lichtemittierenden Halbleitervorrichtungen (1100b) und die dritten lichtemittierenden Halbleitervorrichtungen (1100c) lichtemittierende Halbleitervorrichtungen (1100) sind, die Licht in verschiedenen Farben emittieren.

9. Verfahren nach einem der Ansprüche 6 bis 8, wobei die lichtemittierenden Halbleitervorrichtungen (1100) erste lichtemittierende Halbleitervorrichtungen (1100a) mit einer höheren elektrischen Leitfähigkeit und einer niedrigeren Dielektrizitätskonstante als die Flüssigkeit und zweite lichtemittierende Halbleitervorrichtungen (1100b) mit einer niedrigeren elektrischen Leitfähigkeit und einer höheren Dielektrizitätskonstante als die Flüssigkeit aufweisen.

10. Verfahren nach einem der Ansprüche 6 bis 9, wobei die lichtemittierenden Halbleitervorrichtungen (1100) eine Passivierungsschicht aufweisen, die so angeordnet ist, dass sie Oberflächen der lichtemittierenden Halbleitervorrichtungen (1100) bedeckt, und
wobei die lichtemittierenden Halbleitervorrichtungen (1100) lichtemittierende Halbleitervorrichtungen (1100) aufweisen, bei denen mindestens eine Dicke oder ein Material der Passivierungsschicht sich von derjenigen anderer lichtemittierender Halbleitervorrichtungen (1100) unterscheidet.

## Revendications

1. Substrat pour la fabrication d'un dispositif d'affichage, ledit substrat (1000) comprenant :
une partie de base (1010) ;
des électrodes en paires (1020) disposées sur la partie de base (1010) de manière à s'étendre dans une direction d'extension ;
une couche diélectrique (1030) disposée sur la partie de base (1010) de manière à recouvrir les électrodes en paires (1020) ;
une partie de paroi de séparation (1040) disposée sur la couche diélectrique (1030) ; et
des cellules (1041) définies par la partie de paroi de séparation (1040) et disposées de manière à chevaucher les électrodes en paires (1020) dans la direction d'extension des électrodes en paires (1020),
où les électrodes en paires (1020) sont disposées à différents intervalles,
ledit substrat comprenant en outre :
une pastille d'électrode (1200) prévue pour appliquer une tension aux électrodes en paires (1020),
ladite pastille d'électrode (1200) comprenant :
une première pastille d'électrode (1210) connectée à une électrode des électrodes en paires (1020) pour lui appliquer un premier signal ; et
un deuxième pastille d'électrode (1220) connectée à une autre électrode des électrodes en paires (1020) pour lui appliquer un deuxième signal,
**caractérisé en ce que**
la tension est une pluralité de différentes tensions alternatives ayant des fréquences différentes, appliquées respectivement aux électrodes en paires.

2. Substrat selon la revendication 1, où les électrodes en paires (1020) comprennent :
des premières électrodes en paires disposées à de premiers intervalles ;
des deuxièmes électrodes en paires disposées à de deuxièmes intervalles ; et
des troisièmes électrodes en paires disposées à de troisièmes intervalles.

3. Substrat selon la revendication 2, où les cellules (1041) comprennent :
des premières cellules ayant une première forme, de manière à chevaucher les premières électrodes en paires ;
des deuxièmes cellules ayant une deuxième forme, de manière à chevaucher les deuxièmes électrodes en paires ; et
des troisièmes cellules ayant une troisième forme, de manière à chevaucher les troisièmes électrodes en paires.

4. Substrat selon la revendication 2 ou la revendication 3, où les premières électrodes en paires, les deuxièmes électrodes en paires et les troisièmes électrodes en paires sont disposées de manière alternée sur la partie de base (1010).

5. Substrat selon la revendication 4, où les électrodes en paires (1020) comprennent des premières électrodes en paires disposées à de premiers intervalles, des deuxièmes électrodes en paires disposées à de deuxièmes intervalles, et des troisièmes électrodes en paires disposées à de troisièmes intervalles, et
où les premières électrodes en paires, les deuxièmes électrodes en paires et les troisièmes électrodes en paires sont connectées respectivement à différentes premières et deuxièmes pastilles d'électrodes (1210, 1220).

6. Procédé de fabrication d'un dispositif d'affichage, ledit procédé comprenant :
la mise en place de dispositifs électroluminescents à semi-conducteur (1100) dans une chambre contenant un fluide, et le transfert d'un substrat (1000) comprenant des cellules (1041) sur lesquelles les dispositifs électroluminescents à semi-conducteur (1100) doivent être positionnés vers un emplacement d'assemblage ;
l'application d'une force magnétique aux dispositifs électroluminescents à semi-conducteur (1100) pour déplacer lesdits dispositifs électroluminescents à semi-conducteur (1100) dans une direction ; et
la formation d'un champ électrique sur le substrat (1000) pour permettre aux dispositifs électroluminescents à semi-conducteur (1100) en mouvement d'être positionnés sur les cellules (1041),
où le substrat (1000) comprend des premières électrodes en paires disposées à de premiers intervalles, des deuxièmes électrodes en paires disposées à de deuxièmes intervalles, et des troisièmes électrodes en paires disposées à de troisièmes intervalles, et où
différentes tensions sont appliquées respectivement aux premières électrodes en paires, aux deuxièmes électrodes en paires et aux troisièmes électrodes en paires pour former des champs électriques sur le substrat (1000), et
**caractérisé en ce que**
les différentes tensions comprennent des tensions alternatives ayant des fréquences différentes appliquées respectivement aux premières électrodes en paires, aux deuxièmes électrodes en paires et aux troisièmes électrodes en paires.

7. Procédé selon la revendication 6, où les cellules (1041) comprennent des premières cellules ayant une première forme de manière à chevaucher les premières électrodes en paires, des deuxièmes cellules ayant une deuxième forme de manière à chevaucher les deuxièmes électrodes en paires, et des troisièmes cellules ayant une troisième forme de manière à chevaucher les troisièmes électrodes en paires.

8. Procédé selon la revendication 6 ou la revendication 7, où les dispositifs électroluminescents à semi-conducteur (1100) comprennent des premiers dispositifs électroluminescents à semi-conducteur (1100a) ayant une première forme, des deuxièmes dispositifs électroluminescents à semi-conducteur (1100b) ayant une deuxième forme, et des troisièmes dispositifs électroluminescents à semi-conducteur (1100c) ayant une troisième forme, et
où les premiers dispositifs électroluminescents à semi-conducteur (1100a), les deuxièmes dispositifs électroluminescents à semi-conducteur (1100b) et les troisièmes dispositifs électroluminescents à semi-conducteur (1100c) sont des dispositifs électroluminescents à semi-conducteur (1100) émettant de la lumière de différentes couleurs.

9. Procédé selon l'une des revendications 6 à 8, où les dispositifs électroluminescents à semi-conducteur (1100) comprennent des premiers dispositifs électroluminescents à semi-conducteur (1100a) ayant une conductivité électrique supérieure et une constante diélectrique inférieure par rapport au fluide, et des deuxièmes dispositifs électroluminescents à semi-conducteur (1100b) ayant une conductivité électrique inférieure et une constante diélectrique supérieure par rapport au fluide.

10. Procédé selon l'une des revendications 6 à 9, où les dispositifs électroluminescents à semi-conducteur (1100) comprennent une couche de passivation disposée de manière à recouvrir les surfaces des dispositifs électroluminescents à semi-conducteur (1100), et
où les dispositifs électroluminescents à semi-conducteur (1100) comprennent des dispositifs électroluminescents à semi-conducteur (1100) où l'épaisseur et/ou le matériau de la couche de passivation sont différents de ceux d'autres dispositifs électroluminescents à semi-conducteur (1100).
